(19) Europäisches Patentamt / European Patent Office / Office européen des brevets

(11) **EP 4 243 591 A1**

(12) **EUROPEAN PATENT APPLICATION**

(43) Date of publication:
**13.09.2023 Bulletin 2023/37**

(21) Application number: **23160300.2**

(22) Date of filing: **06.03.2023**

(51) International Patent Classification (IPC):
**H10K 59/131** (2023.01)     **H10K 59/80** (2023.01)
**H10K 71/70** (2023.01)

(52) Cooperative Patent Classification (CPC):
**H10K 71/70; H10K 59/131; H10K 59/873**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.03.2022 KR 20220029669**

(71) Applicant: **Samsung Display Co., Ltd.**
**Yongin-si, Gyeonggi-do 17113 (KR)**

(72) Inventors:
• **SEO, Seung Woo**
  **Yongin-si (KR)**
• **PARK, Yoon Kyoung**
  **Yongin-si (KR)**
• **LEE, Seung Jae**
  **Yongin-si (KR)**
• **KWACK, Jin Ho**
  **Yongin-si (KR)**
• **CHOI, Young Seo**
  **Yongin-si (KR)**

(74) Representative: **Marks & Clerk LLP**
**15 Fetter Lane**
**London EC4A 1BW (GB)**

(54) **MANUFACTURING METHOD OF DISPLAY PANEL**

(57)     A manufacturing method of a display panel includes forming pixels in a display area of a substrate, and forming a metal wiring and a dam portion in a non-display area of the substrate, forming an encapsulation layer using an inorganic insulating material and an organic insulating material to cover the display area of the substrate and inspecting the presence or absence of a remaining layer including the organic insulating material, which is formed in a remaining area of the encapsulation layer except for the display area, using a filter having a predetermined wavelength range.

**FIG. 15**

EP 4 243 591 A1

**Description**

BACKGROUND

1. Field

The disclosure relates to a manufacturing method of a display panel.

2. Description of the Related Art

As an information-oriented society evolves, various demands for display devices are ever increasing. In an embodiment, display devices are being employed by a variety of electronic devices such as smart phones, digital cameras, laptop computers, navigation devices, and smart televisions.

Display devices may be flat panel display devices such as a liquid-crystal display device, a field emission display device, and a light-emitting display device. Examples of the light-emitting display device include an organic light-emitting display device composed of organic light-emitting elements, an inorganic light-emitting display device composed of inorganic light-emitting elements such as inorganic semiconductors, and a micro light-emitting display device composed of micro light-emitting elements.

SUMMARY

The conventional display device may include an organic layer, and the organic layer may be formed, e.g., by an inkjet method. In this process, there was a problem in that the organic layer was formed to overflow to the outside of the formation region thereof.

However, features of the disclosure are not restricted to the one set forth herein. The above and other features of the disclosure will become more apparent to one of ordinary skill in the art to which the disclosure pertains by referencing the detailed description of the disclosure given below.

In an embodiment of the disclosure, a manufacturing method of a display panel includes forming pixels in a display area of a substrate, and forming a metal wiring and a dam portion in a non-display area of the substrate, forming an encapsulation layer using an inorganic insulating material and an organic insulating material to cover the display area of the substrate and inspecting presence or absence of a remaining layer including the organic insulating material, which is formed in a remaining area of the encapsulation layer except for the display area, using a filter having a predetermined wavelength range.

In an embodiment, the manufacturing method of a display panel may further include removing the remaining layer when it is determined that the remaining layer is present as a result of the inspecting.

In an embodiment, the forming the metal wiring and the dam portion in the non-display area of the substrate may include forming the metal wiring by patterning after depositing a conductive layer in the non-display area of the substrate.

In an embodiment, the plurality of permeation prevention patterns protruding outward may be formed in the metal.

In an embodiment, the plurality of permeation prevention patterns may have a circular shape, an elliptic shape, or a polygonal shape in a plan view.

In an embodiment, the forming the encapsulation layer may include disposing an inorganic encapsulation layer including the inorganic insulating material to cover the display area, dropping droplets of the organic insulating material on the inorganic encapsulation layer, waiting until the droplets are diffused throughout the display area and forming an organic encapsulation layer by curing the diffused droplets.

In an embodiment, the forming the dam portion may include forming a bank including a dam and a plurality of organic layers outside the dam.

In an embodiment, the forming the dam portion may include forming a bank including a first dam, a second dam outside the first dam, and a plurality of organic layers outside the second dam.

In an embodiment, the inspecting the presence or the absence of the remaining layer including the organic insulating material, which is formed in the remaining area of the encapsulation layer except for the display area, using the filter having the predetermined wavelength range may include irradiating monochromatic light to the remaining area of the substrate except for the display area and observing the monochromatic light reflected from the substrate with a microscope to check interference fringes.

In an embodiment, the remaining area may include at least one of the dam portion and the metal wiring.

In an embodiment, the inspecting the presence or the absence of the remaining layer may include irradiating the monochromatic light to any one or more of a top surface, a bottom surface, and a side surface of the substrate and observing the monochromatic light reflected from the substrate with the microscope to check the interference fringes.

In an embodiment, the removing the remaining layer may include removing the remaining layer by a plasma ashing process.

In an embodiment, the conditions of the plasma ashing process may be controlled based on a difference in intervals of the interference fringes corresponding to a thickness of the remaining layer.

In an embodiment, the predetermined wavelength range may be from about 575 nanometers (nm) to about 585 nm.

In an embodiment of the disclosure, a manufacturing method of a display panel includes forming pixels and defining a component hole in a display area of a substrate, and forming a metal wiring and a dam portion in a non-display area of the substrate, forming an encapsulation layer using an inorganic insulating material and an organic insulating material to cover the display area of the substrate except for the component hole and inspecting presence or absence of a remaining layer including the organic insulating material, which is formed on a side surface of the component hole and in a remaining area of the encapsulation layer except for the display area, using a filter having a predetermined wavelength range.

In an embodiment, the manufacturing method of a display panel may further include removing the remaining layer when it is determined that the remaining layer is present as a result of the inspecting.

In an embodiment, the component hole may overlap a region where a component is disposed.

In an embodiment, the component may include any one of an illuminance sensor, an iris sensor, and a camera.

In an embodiment, the forming the metal wiring and the dam portion in the non-display area of the substrate may include forming the metal wiring by patterning after depositing a conductive layer in the non-display area of the substrate.

In an embodiment, a plurality of permeation prevention patterns protruding outward may be formed in the metal wiring.

In an embodiment, the plurality of permeation prevention patterns may have a circular shape, an elliptic shape, or a polygonal shape in a plan view.

In an embodiment, the forming the pixels and the defining the component hole in the display area of the substrate, and forming the metal wiring and the dam portion in the non-display area of the substrate may include disposing a lower metal layer on the substrate in a component area where the component hole is defined, and forming the pixels on the lower metal layer.

In an embodiment, the forming the encapsulation layer may include disposing an inorganic encapsulation layer including the inorganic insulating material to cover the display area of the substrate except for the component hole, dropping droplets of the organic insulating material on the inorganic encapsulation layer, waiting until the droplets are diffused throughout the display area and forming an organic encapsulation layer by curing the diffused droplets.

In an embodiment, the forming the dam portion may include forming a bank including a dam and plurality of organic layers outside the dam.

In an embodiment, the forming the dam portion may include forming a bank including a first dam, a second dam outside the first dam, and a plurality of organic layers outside the second dam.

In an embodiment, the inspecting the presence or the absence of the remaining layer including the organic insulating material, which is formed on the side surface of the component hole and in the remaining area except for the display area may include irradiating monochromatic light to the side surface of the component hole and the remaining area except for the display area and observing the monochromatic light reflected from the substrate with a microscope to check interference fringes.

In an embodiment, the remaining area may include at least one of the dam portion and the metal wiring.

In an embodiment, the inspecting the presence or the absence of the remaining layer may include irradiating the monochromatic light to any one or more of a top surface, a bottom surface, and a side surface of the substrate and observing the monochromatic light reflected from the substrate with the microscope to check the interference fringes.

At least some of the above and other features of the invention are set out in the claims.

In accordance with a manufacturing method of a display panel in embodiments, visibility of a remaining layer, which is formed by an overflow of an organic encapsulation layer to the outside of the formation region thereof, is improved without affecting a structure of a display panel. Accordingly, it is possible to increase productivity due to the decrease in a defective runoff rate of the display panel.

Further, in accordance with the manufacturing method of the display panel in the embodiments, since the height of the remaining layer may be checked, it is possible to optimize ashing for removing the remaining layer. Accordingly, the yield in manufacturing the display panel may be improved.

Furthermore, in accordance with the manufacturing method of the display panel in the embodiments, a hitting margin of the organic encapsulation layer may be decreased, thereby reducing the number of dam structures or removing the dam structures. Accordingly, it is possible to decrease the thickness of a bezel.

However, the effects of the disclosure are not limited to the aforementioned effects, and various other effects are included in the specification.

BRIEF DESCRIPTION OF THE DRAWINGS

The above and other amendments, advantages and features of the disclosure will become more apparent by describing in detail embodiments thereof with reference to the attached drawings, in which:

FIG. 1 is a perspective view illustrating an embodiment of a display device;
FIGS. 2 and 3 are plan views illustrating an embodiment of a display device;
FIG. 4 is a side view illustrating an embodiment of a display device;
FIG. 5 is a cross-sectional view illustrating an embodiment of a display panel taken along line I-I' of FIG. 3;
FIG. 6 is a plan view illustrating an embodiment of a non-display area of a display panel;
FIG. 7 is a plan view illustrating in detail an embodiment of a dam area, an inorganic encapsulation area, and a bank area;
FIG. 8 is a cross-sectional view illustrating an embodiment of the display panel taken along line B-B' of FIG. 7;
FIG. 9 is a cross-sectional view illustrating an embodiment of the display panel taken along line C-C' of FIG. 7;
FIG. 10 is a cross-sectional view illustrating an embodiment of a display panel taken along line B-B' of FIG. 7;
FIG. 11 is a plan view illustrating an embodiment of a display device;
FIG. 12 is a plan view illustrating an embodiment of a display device;
FIG. 13 is a side view illustrating an embodiment of a display device;
FIG. 14 is a cross-sectional view illustrating an embodiment of a display panel taken along line P-P' of FIG. 11;
FIG. 15 is a flowchart showing an embodiment of a manufacturing method of a display panel according to the disclosure;
FIGS. 16 and 18 are cross-sectional views illustrating an embodiment of a manufacturing method of a display panel according to the disclosure;
FIG. 19 is a diagram for explaining an embodiment of a formation of interference fringes;
FIG. 20 is a diagram for explaining an embodiment of an inspection device;
FIG. 21 is a diagram illustrating an embodiment of interference fringes formed by an organic encapsulation layer corresponding to the dam area DAMA and the first non-display area NDA1 of FIG. 18;
FIG. 22 is a flowchart illustrating an embodiment of a manufacturing method of a display panel according to the disclosure; and
FIGS. 23 and 24 are cross-sectional views illustrating an embodiment of the manufacturing method of the display panel according to the disclosure.

DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying drawing figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein are inclusive of the stated value and mean within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within $\pm$ 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

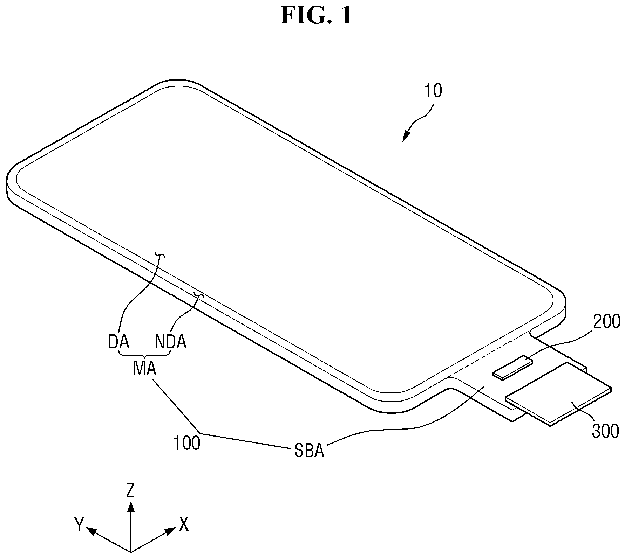

FIG. 1 is a perspective view illustrating an embodiment of a display device.

Referring to FIG. 1, a display device 10 is a device for displaying a moving image or a still image. The display device 10 may be used as a display screen of various devices, such as a television, a laptop computer, a monitor, a billboard and an Internet-of-Things ("IoT") device, as well as portable electronic devices such as a mobile phone, a smartphone, a tablet personal computer ("PC"), a smart watch, a watch phone, a mobile communication terminal, an electronic notebook, an electronic book, a portable multimedia player ("PMP"), a navigation device and an ultra-mobile PC ("UMPC").

The display device 10 may be a light-emitting display device such as an organic light-emitting display using an organic light-emitting diode, a quantum dot light-emitting display including a quantum dot light-emitting layer, an inorganic light-emitting display including an inorganic semiconductor, and a micro light-emitting display using a micro or nano light-emitting diode ("LED"). In the following description, it is assumed that the display device 10 is an organic light-emitting display device, but the disclosure is not limited thereto.

The display device 10 includes a display panel 100, a display driving circuit 200, and a circuit board 300.

The display panel 100 may be formed in a quadrangular (e.g., rectangular) shape, in a plan view, having short sides in a first direction (X-axis direction) and long sides in a second direction (Y-axis direction) crossing the first direction (X-axis direction). The corner where the short side in the first direction (X-axis direction) and the long side in the second direction (Y-axis direction) meet may be rounded to have a predetermined curvature or may be right-angled. The planar shape of the display panel 100 is not limited to the quadrangular (e.g., rectangular) shape, and may be formed in another polygonal shape, a circular shape or an elliptical shape. The display panel 100 may be flat, but is the disclosure is not limited thereto. In an embodiment, the display panel 100 may include a curved portion formed at left and right ends and having a predetermined curvature or a varying curvature, for example. In addition, the display panel 100 may be formed flexibly so that it may be curved, bent, folded, or rolled.

The display panel 100 may include a main region MA and a sub-region SBA.

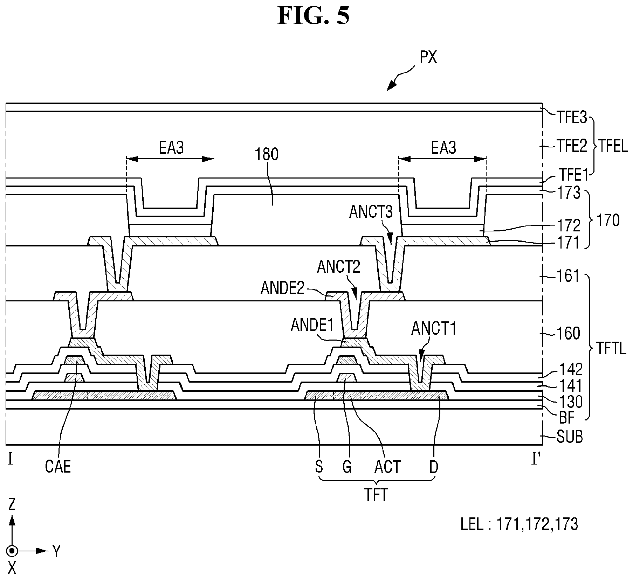

The main region MA may include a display area DA displaying an image and a non-display area NDA that is a peripheral area of the display area DA. The display area DA may include pixels (refer to FIG. 5) for displaying an image. The sub-region SBA may protrude in the second direction (Y-axis direction) from one side of the main region MA.

Although it is shown in FIG. 1 that the sub-region SBA is unfolded, the sub-region SBA may be bent and, in this case, arranged on the bottom surface of the display panel 100. In the case where the sub-region SBA is bent, it may overlap the main region MA in the third direction or thickness direction (Z-axis direction) of the substrate SUB. The display driving circuit 200 may be arranged in the sub-region SBA.

The display driving circuit 200 may generate signals and voltages for driving the display panel 100. The display driving circuit 200 may be formed as an integrated circuit ("IC") and attached onto the display panel 100 by a chip on glass ("COG") method, a chip on plastic ("COP") method, or an ultrasonic bonding method, but the disclosure is not limited thereto. In an embodiment, the display driving circuit 200 may be attached onto the circuit board 300 by a chip on film ("COF") method, for example.

The circuit board 300 may be attached to one end of the sub-region SBA of the display panel 100. Thus, the circuit board 300 may be electrically connected to the display panel 100 and the display driving circuit 200. The display panel 100 and the display driving circuit 200 may receive digital video data, timing signals, and driving voltages through the circuit board 300. The circuit board 300 may be a flexible printed circuit board, a printed circuit board, or a flexible film such as a COF.

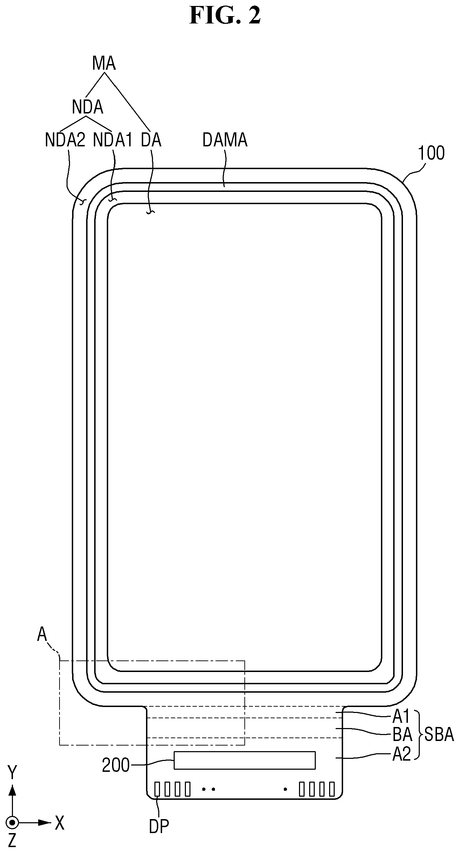

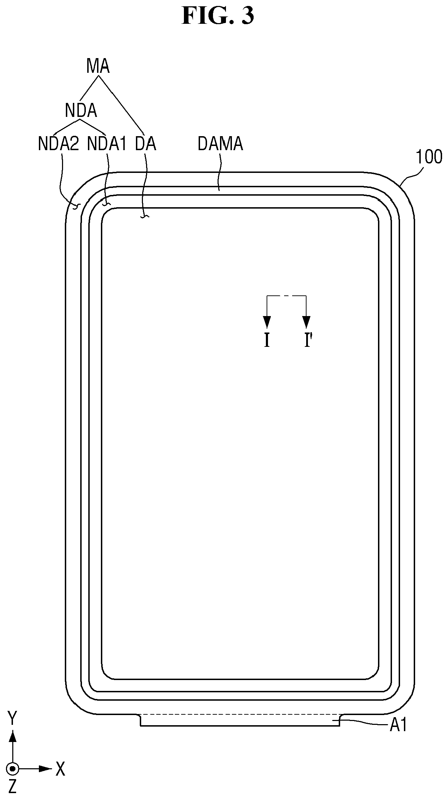

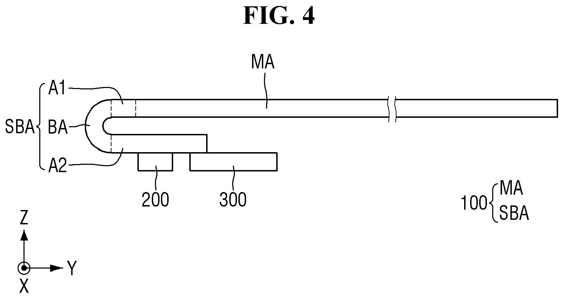

FIGS. 2 and 3 are plan views illustrating an embodiment of a display device. FIG. 4 is a side view illustrating an embodiment of a display device.

It is shown in FIG. 2 that the sub-region SBA is unfolded without being bent. It is shown in FIGS. 3 and 4 that the sub-region SBA is bent.

Referring to FIGS. 2 to 4, the display panel 100 may include the main region MA and the sub-region SBA.

The main region MA may include a display area DA displaying an image and a non-display area NDA that is a peripheral area of the display area DA. The display area DA may occupy most of the main region MA. The display area DA may be disposed at the center of the main region MA.

The non-display area NDA may be disposed adjacent to the display area DA. The non-display area NDA may be an area outside the display area DA. The non-display area NDA may be disposed to surround the display area DA. The non-display area NDA may be an edge area of the display area DA.

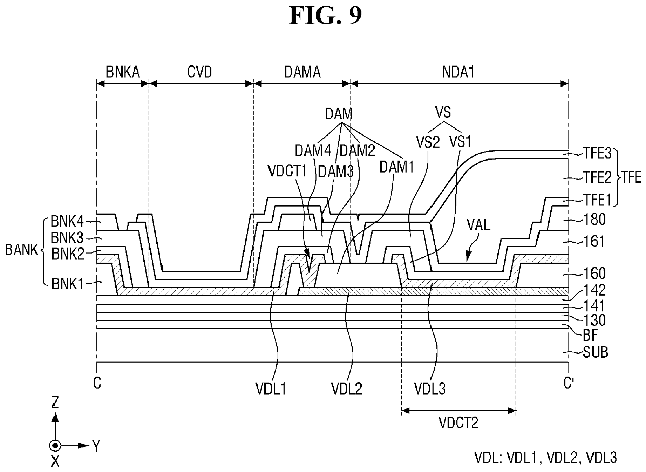

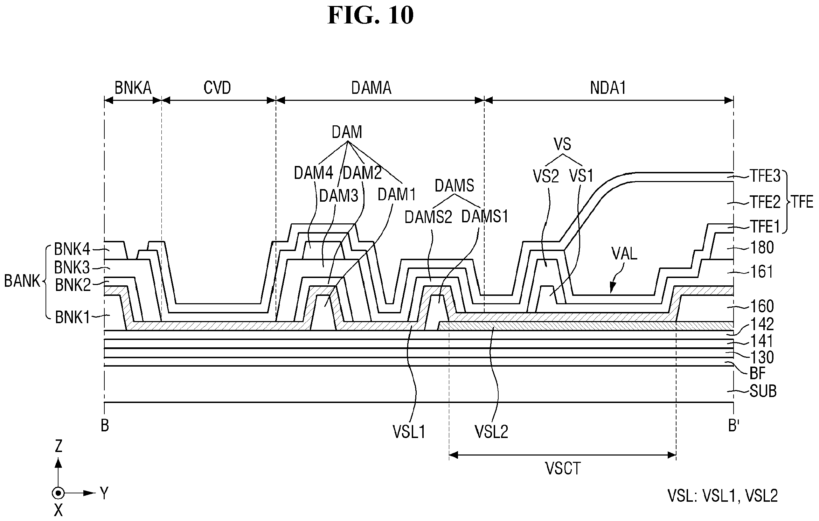

The non-display area NDA may include a dam area DAMA. The dam area DAMA may be disposed to surround the display area DA. The dam area DAMA may be an area in which a dam ('DAM' of FIGS. 9 and 10) is disposed to prevent an overflow of an organic encapsulation layer TFE2 of an encapsulation layer ('TFEL' of FIG. 5) for encapsulating the light-emitting elements of the display area DA.

The non-display area NDA may include a first non-display area NDA1 disposed between the display area DA and the dam area DAMA and a second non-display area NDA2 disposed outside the dam area DAMA. That is, the first non-display area NDA1 may be disposed inside the dam area DAMA, and the second non-display area NDA2 may be disposed outside the dam area DAMA.

The sub-region SBA may protrude in the second direction (Y-axis direction) from one side of the main region MA. The length of the sub-region SBA in the second direction (Y-axis direction) may be less than the length of the main region MA in the second direction (Y-axis direction). The length of the sub-region SBA in the first direction (X-axis direction) may be substantially equal to or less than the length of the main region MA in the first direction (X-axis direction). The sub-region SBA may be bent so as to be placed on the bottom surface of the display panel 100. In this case, the sub-region SBA may overlap the main region MA in a third direction (Z-axis direction).

The sub-region SBA may include a first region A1, a second region A2, and a bending area BA.

The first region A1 is a region protruding from one side of the main region MA in the second direction (Y-axis direction). One side of the first region A1 may contact the non-display area NDA of the main region MA, and the other side of the first region A1 may contact the bending area BA.

The second region A2 is an area on which display pads DP and the display driving circuit 200 are disposed. The display driving circuit 200 may be attached to driving pads of the second region A2 using a low-resistance high-reliability material such as self-assembly anisotropic conductive paste ("SAP") or an anisotropic conductive film. The display pad DP is not covered by an insulating layer and is exposed to be connected to the circuit board 300.

The circuit board 300 may be attached to the display pads DP of the second region A2 using a low-resistance high-reliability material such as SAP or an anisotropic conductive film. One side of the second region A2 may contact the bending area BA.

The bending area BA is an area being bent. When the bending area BA is bent, the second region A2 may be disposed under the first region A1 and under the main region MA. The bending area BA may be disposed between the first region A1 and the second region A2. One side of the bending area BA may contact the first region A1, and the other side of the bending area BA may contact the second region A2.

FIG. 5 is a cross-sectional view illustrating an embodiment of a display panel taken along line I-I' of FIG. 3.

Referring to FIG. 5, the substrate SUB may include an insulating material such as polymer resin or glass. In an embodiment, the substrate SUB may include polyimide. In this case, the substrate SUB may be a flexible substrate which may be bent, folded or rolled.

A thin film transistor layer TFTL including thin film transistors TFT may be disposed on the substrate SUB. The thin film transistor layer TFTL may include thin film transistors TFT, a capacitor, a first anode connection electrode ANDE1, a second anode connection electrode ANDE2, a buffer layer BF, a gate insulating layer 130, a first inter-insulating layer 141, a second inter-insulating layer 142, a first organic layer 160, and a second organic layer 161.

The buffer layer BF may be disposed on the substrate SUB. The buffer layer BF may include a silicon nitride layer, a silicon oxynitride layer, a silicon oxide layer, a titanium oxide layer, or an aluminium oxide layer.

The thin film transistors TFT may be disposed on the buffer layer BF. The thin film transistor TFT may include an active layer ACT, a gate electrode G, a source electrode S, and a drain electrode D. The active layer ACT may include a silicon semiconductor such as polycrystalline silicon, monocrystalline silicon, low-temperature polycrystalline silicon, and amorphous silicon. The source electrode S and the drain electrode D may be formed by doping a silicon semiconductor with ions or impurities to have conductivity. The active layer ACT may overlap the gate electrode G in the third direction (Z-axis direction) that is the thickness direction of the substrate SUB, and the source electrode S and the drain electrode D may not overlap the gate electrode G in the third direction (Z-axis direction).

The gate insulating layer 130 may be disposed on the active layer ACT, the source electrode S, and the drain electrode D constituting the thin film transistor TFT. The gate insulating layer 130 may include an inorganic layer, e.g., a silicon nitride layer, a silicon oxynitride layer, a silicon oxide layer, a titanium oxide layer, or an aluminium oxide layer.

The gate electrode G of the thin film transistor TFT may be arranged on the gate insulating layer 130. The gate electrode G may be formed as a single layer or multiple layers including any one of molybdenum (Mo), aluminium (Al), chromium (Cr), gold (Au), titanium (Ti), nickel (Ni), neodymium (Nd) and copper (Cu) or an alloy thereof.

The first inter-insulating layer 141 may be disposed on the gate electrode G. The first inter-insulating layer 141 may include an inorganic layer, e.g., a silicon nitride layer, a silicon oxynitride layer, a silicon oxide layer, a titanium oxide layer, or an aluminium oxide layer.

A capacitor electrode CAE may be disposed on the first inter-insulating layer 141. The capacitor electrode CAE may overlap the gate electrode G in the third direction (Z-axis direction). Since the first inter-insulating layer 141 has a predetermined dielectric constant, a capacitor may be formed by the capacitor electrode CAE, the gate electrode G, and the first inter-insulating layer 141 disposed between the capacitor electrode CAE and the gate electrode G. The capacitor electrode CAE may be formed as a single layer or multiple layers including any one of molybdenum (Mo), aluminium (Al), chromium (Cr), gold (Au), titanium (Ti), nickel (Ni), neodymium (Nd) and copper (Cu) or an alloy thereof.

A second inter-insulating layer 142 may be disposed on the capacitor electrode CAE. The second inter-insulating layer 142 may include an inorganic layer, e.g., a silicon nitride layer, a silicon oxynitride layer, a silicon oxide layer, a titanium oxide layer, or an aluminium oxide layer. The second inter-insulating layer 142 may include a plurality of inorganic layers, and may be larger in thickness than the first inter-insulating layer 141 in the third direction (Z-axis direction).

The first anode connection electrode ANDE1 may be disposed on the second inter-insulating layer 142. The first anode connection electrode ANDE1 may be connected to the drain electrode D via the first anode contact hole ANCT1 penetrating the first and second inter-insulating layers 141 and 142 and the gate insulating layer 130 to expose the drain electrode D of the thin film transistor TFT. The first anode connection electrode ANDE1 may be formed as a single layer or multiple layers including any one of molybdenum (Mo), aluminium (Al), chromium (Cr), gold (Au), titanium (Ti), nickel (Ni), neodymium (Nd) and copper (Cu), or an alloy thereof.

The first organic layer 160 for planarization may be disposed on the first anode connection electrode ANDE1. The first organic layer 160 may include an organic layer such as acryl resin, epoxy resin, phenolic resin, polyamide resin, polyimide resin or the like.

The second anode connection electrode ANDE2 may be disposed on the first organic layer 160. The second anode connection electrode ANDE2 may be connected to the first anode connection electrode ANDE1 via the second anode contact hole ANCT2 penetrating the first organic layer 160 to expose the first anode connection electrode ANDE1. The second anode connection electrode ANDE2 may be formed as a single layer or multiple layers including any one of molybdenum (Mo), aluminium (Al), chromium (Cr), gold (Au), titanium (Ti), nickel (Ni), neodymium (Nd) and copper (Cu), or an alloy thereof.

The second organic layer 161 may be disposed on the second anode connection electrode ANDE2. The second organic layer 161 may include an organic layer such as acryl resin, epoxy resin, phenolic resin, polyamide resin, polyimide resin or the like.

Although FIG. 5 illustrates that the thin film transistor TFT be of a top gate type in which the gate electrode is disposed on top of the active layer, it should be noted that the disclosure is not limited thereto. The thin film transistor TFT may be of a bottom gate type in which the gate electrode is disposed under the active layer or a double gate type in which the gate electrode is disposed on and under the active layer.

The light-emitting element layer 170 may be disposed on the second organic layer 161. The light-emitting element layer 170 may include light-emitting elements LEL and a light-emitting unit defining layer 180. Each of the light-emitting elements LEL includes a pixel electrode 171, a light-emitting layer 172, and a common electrode 173. The common electrode 173 may be connected in common to the plurality of light-emitting elements LEL.

The pixel electrode 171 may be formed on the second organic layer 161. The pixel electrode 171 may be connected to the second anode connection electrode ANDE2 via the third anode contact hole ANCT3 penetrating the second organic layer 161 to expose the second anode connection electrode ANDE2.

In a top emission structure in which light is emitted toward the common electrode 173 when viewed with respect to the light-emitting layer 172, the pixel electrode 171 may include a metal material having high reflectivity such as a stacked structure (Ti/Al/Ti) of aluminium and titanium, a stacked structure (ITO/Al/ITO) of aluminium and ITO, an APC alloy, and a stacked structure (ITO/APC/ITO) of an APC alloy and ITO. The APC alloy is an alloy of silver (Ag), palladium (Pd) and copper (Cu).

The light-emitting unit defining layer 180 may function to define light-emitting units EA3, and thus may partition the pixel electrode 171 on the second organic layer 161. The light-emitting unit defining layer 180 may cover the edge of the pixel electrode 171. The light-emitting unit defining layer 180 may include an organic layer such as acryl resin, epoxy resin, phenolic resin, polyamide resin, polyimide resin or the like.

Each of the light-emitting units EA3 is an area in which the pixel electrode 171, the light-emitting layer 172, and the common electrode 173 are sequentially stacked such that the holes from the pixel electrode 171 and the electrons from the common electrode 173 are combined with each other to emit light.

The light-emitting layer 172 is formed on the pixel electrode 171 and the light-emitting unit defining layer 180. The light-emitting layer 172 may include an organic material to emit light in a predetermined color. In an embodiment, the light-emitting layer 172 includes a hole transporting layer, an organic material layer, and an electron transporting layer, for example.

The common electrode 173 is formed on the light-emitting layer 172. The common electrode 173 may cover the light-emitting layer 172. The common electrode 173 may be a common layer that is commonly formed in all the light-emitting units EA3. A capping layer may be formed on the common electrode 173.

In the top emission structure, the common electrode 173 may include transparent conductive oxide ("TCO") such as indium tin oxide ("ITO") and indium zinc oxide ("IZO") capable of transmitting light or a semi-transmissive conductive material such as magnesium (Mg), silver (Ag), or an alloy of magnesium (Mg) and silver (Ag). When the common electrode 173 includes a semi-transmissive conductive material, the light emission efficiency may be increased due to a micro-cavity effect.

The encapsulation layer TFEL may be disposed on the common electrode 173. The encapsulation layer TFEL includes at least one inorganic layer to prevent oxygen or moisture from permeating into the light-emitting element layer 170. In addition, the encapsulation layer TFEL includes at least one organic layer to protect the light-emitting element layer 170 from foreign substances such as dust. In an embodiment, the encapsulation layer TFEL may include a first inorganic encapsulation layer TFE1, an organic encapsulation layer TFE2, and a second inorganic encapsulation layer TFE3, for example.

The first inorganic encapsulation layer TFE1 may be disposed on the common electrode 173, the organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may include multiple layers in which one or more inorganic layers of a silicon nitride layer, a silicon oxynitride layer, a silicon oxide layer, a titanium oxide layer and an aluminium oxide layer are alternately stacked. The organic encapsulation layer TFE2 may include acryl resin, epoxy resin, phenolic resin, polyamide resin, polyimide resin or the like.

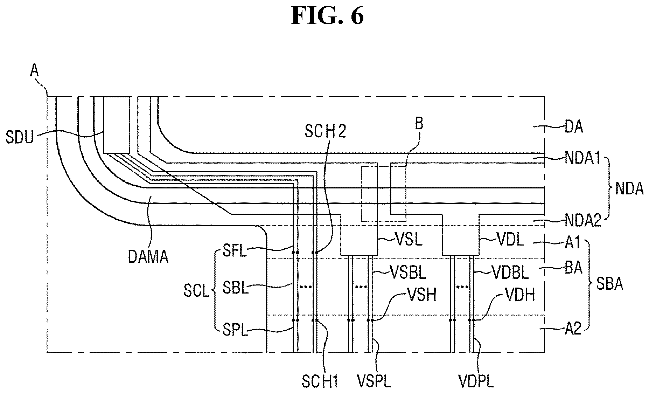

FIG. 6 is a plan view illustrating an embodiment of a non-display area of a display panel. FIG. 6 is a plan view showing in detail an embodiment of area A of FIG. 2.

For simplicity of description, FIG. 6 illustrates a scan driver SDU, scan control lines SCL, a first power line VSL, a first power pad line VSPL, a first power bending line VSBL, a second power line VDL, a second power pad line VDPL, and a second power bending line VDBL.

Referring to FIG. 6, the scan driver SDU may be disposed on the left side of the display area DA. The scan driver SDU may be connected to the display driving circuit 200 via the scan control lines SCL. The scan driver SDU may receive a scan timing signal from the display driving circuit 200 via the scan control lines SCL. The scan driver SDU may generate scan signals according to the scan timing signal. The scan driver SDU may output the scan signals to the scan lines of the display area DA.

Each of the scan control lines SCL may include a scan fan-out line SFL, a scan pad line SPL, and a scan bending line SBL.

The scan fan-out line SFL may be disposed in the non-display area NDA and a first region A1 of the sub-region SBA. The scan fan-out line SFL may be disposed between the scan driver SDU and the scan bending line SBL. One end of the scan fan-out line SFL may be connected to the scan driver SDU, and the other end thereof may be connected to the scan bending line SBL through a second scan contact hole SCT2. The scan fan-out line SFL may overlap the dam area DAMA.

The scan bending line SBL may be disposed in the first region A1, a second region A2, and a bending area BA of the sub-region SBA. The scan bending line SBL may be disposed between the scan fan-out line SFL and the scan pad line SPL. One end of the scan bending line SBL may be connected to the scan fan-out line SFL through the second scan contact hole SCT2 in the first region A1, and the other end thereof may be connected to the scan pad line SPL through a first scan contact hole SCT1 in the second region A2.

The scan pad line SPL may be disposed in the second region A2. The scan pad line SPL may be disposed between the scan bending line SBL and the display driving circuit 200. One end of the scan pad line SPL may be connected to the scan bending line SBL through the first scan contact hole SCT1, and the other end thereof may be connected to the display driving circuit 200.

For simplicity of description, data connection lines (not shown), which are disposed between the data lines of the display area DA and the display driving circuit 200, are omitted in FIG. 6, but the data connection lines (not shown) may be configured similarly to the scan control lines SCL. The data lines may receive data voltages from the display driving circuit 200 via the data connection lines. Each of the data connection lines (not shown) may include a data fan-out line (not shown), a data pad line (not shown), and a data bending line (not shown). The data fan-out line (not shown), the data pad line (not shown), and the data bending line (not shown) may be substantially the same as the scan fan-out line SFL, the scan pad line SPL, and the scan bending line SBL, respectively.

The first power line VSL may be disposed in the non-display area NDA. The first power line VSL may overlap the dam area DAMA. The first power line VSL may overlap the scan fan-out lines SFL. The first power line VSL may be disposed between the scan driver SDU and the display area DA. In an alternative embodiment, the first power line VSL may overlap the scan driver SDU.

The first power bending lines VSBL may be disposed in the first region A1, the second region A2, and the bending area BA of the sub-region SBA. Each of the first power bending lines VSBL may be disposed between the first power line VSL and the first power pad line VSPL corresponding thereto. The first power bending lines VSBL may extend from the first power line VSL. The first power bending lines VSBL and the first power line VSL may be formed as one body. That is, the first power bending lines VSBL may include the same material as that of the first power line VSL. Each of the first power bending lines VSBL may be connected to the corresponding first power pad line VSPL through a first power contact hole VSH.

The first power pad lines VSPL may be disposed in the second region A2. Each of the first power pad lines VSPL may be disposed between the first power bending line VSBL corresponding thereto and the display driving circuit 200. One end of each first power pad line VSPL may be connected to the corresponding first power bending line VSBL through the corresponding first power contact hole VSH, and the other end thereof may be connected to the display driving circuit 200.

The second power line VDL may be disposed in the non-display area NDA. The second power line VDL may overlap the dam area DAMA. The second power line VDL may overlap data connection lines (not shown).

The second power bending lines VDBL may be disposed in the first region A1, the second region A2, and the bending area BA of the sub-region SBA. Each of the second power bending lines VDBL may be disposed between the second power line VDL and the second power pad line VDPL corresponding thereto. The second power bending lines VDBL may extend from the second power line VDL. The second power bending lines VDBL and the second power line VDL may be formed as one body. That is, the second power bending lines VDBL may include the same material as that of the second power line VDL. Each of the second power bending lines VDBL may be connected to the corresponding second power pad line VDPL through a second power contact hole VDH.

The second power pad lines VDPL may be disposed in the second region A2. Each of the second power pad lines VDPL may be disposed between the corresponding second power bending line VDBL and the display driving circuit 200. One end of each second power pad line VDPL may be connected to the corresponding second power bending line VDBL through the corresponding second power contact hole VDH, and the other end thereof may be connected to the display driving circuit 200.

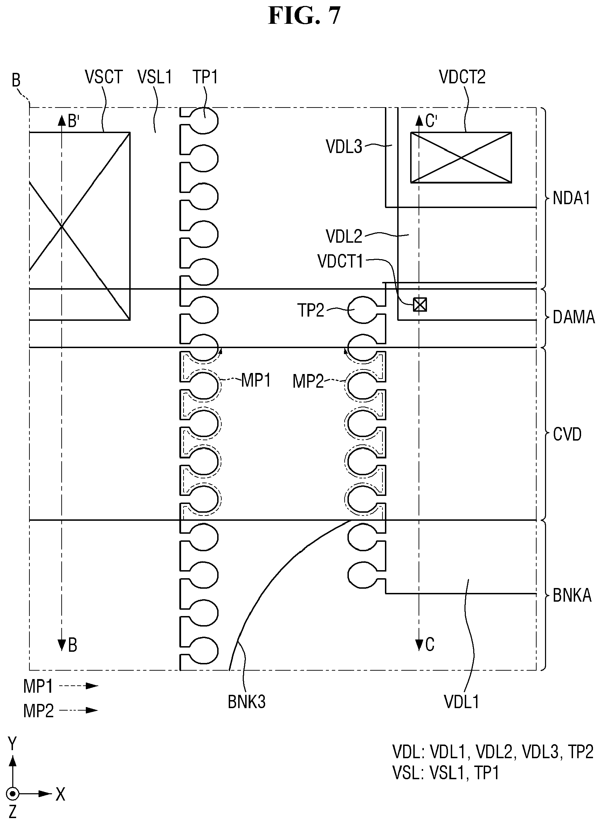

FIG. 7 is a plan view illustrating in detail an embodiment of a dam area, an inorganic encapsulation area, and a bank area. FIG. 7 is a plan view showing in detail an embodiment of area B of FIG. 6.

Referring to FIG. 7, the non-display area NDA may include the first non-display area NDA1, the dam area DAMA, an inorganic encapsulation area CVD, and a bank area BNKA.

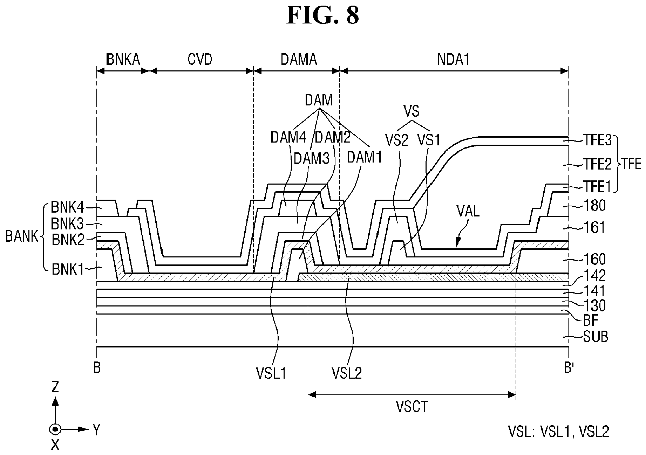

The dam area DAMA may be an area in which the dam ('DAM' of FIG. 8) is disposed to prevent an overflow of the organic encapsulation layer TFE2 of the encapsulation layer ('TFEL' of FIG. 5 ) for encapsulating the light-emitting elements of the display area DA. The dam area DAMA may be disposed in the non-display area NDA disposed below the display area DA, in the first direction (X-axis direction). The dam ('DAM' of FIG. 8) will be described later in detail in conjunction with FIG. 8.

The bank area BNKA may be an area in which a bank ('BANK' of FIG. 8) is disposed to support a mask when the display panel 100 is manufactured. The bank area BNKA may be disposed in the non-display area NDA disposed below the display area DA, in the first direction (X-axis direction). The bank ('BANK' of FIG. 8) will be described later in detail in conjunction with FIG. 8.

The first non-display area NDA1 may be an area disposed between the dam area DAMA and the display area DA in the non-display area NDA as shown in FIG. 2. The first non-display area NDA1 may be disposed inside the dam area DAMA, and the second non-display area NDA2 may be disposed outside the dam area DAMA.

The inorganic encapsulation area CVD may be disposed between the dam area DAMA and the bank area BNKA. The inorganic encapsulation area CVD may be an area in which the first inorganic encapsulation layer TFE1 and the second inorganic encapsulation layer TFE3 of the encapsulation layer ('TFEL' of FIG. 5) contact each other to encapsulate the display panel 100. The inorganic encapsulation area CVD may be an area where only an inorganic layer is disposed and an organic layer is not disposed. The inorganic encapsulation area CVD may be arranged in the non-display area NDA disposed below the display area DA, in the first direction (X-axis direction).

The first power line VSL for supplying a first power voltage to the common electrode ('173' of FIG. 5) may be disposed in the non-display area NDA. The first power line VSL may include a plurality of first sub-power lines VSL1 and a plurality of first permeation prevention patterns TP1.

The first sub-power line VSL1 may be disposed in the second direction (Y-axis direction). The first sub-power line VSL1 may be disposed in the first non-display area NDA1, the dam area DAMA, the inorganic encapsulation area CVD, and the bank area BNKA. The first sub-power line VSL1 may be connected to a second sub-power line VSL2 through a first power contact hole VSCT. Accordingly, the resistance of the first power line VSL may be decreased, so that the first power voltage may be supplied more uniformly regardless of the location of the light-emitting units (not shown) disposed in the display area DA.

In the inorganic encapsulation area CVD, the first sub-power line VSL1 may not be properly covered by the first inorganic encapsulation layer TFE1 and the second inorganic encapsulation layer TFE3 due to the inclination of the side surface of the first sub-power line VSL1. That is, in the inorganic encapsulation area CVD, voids may be generated in the first inorganic encapsulation layer TFE1 and the second inorganic encapsulation layer TFE3 due to the inclination of the side surface of the first sub-power line VSL1. The voids may become a permeation passage of external air or moisture.

The plurality of first permeation prevention patterns TP1 may protrude from one side of the first sub-power line VSL1 in the first direction (X-axis direction). The plurality of first permeation prevention patterns TP1 may be disposed in the second direction (Y-axis direction).

In the inorganic encapsulation area CVD, the voids may be formed along the side surface of the first sub-power line VSL1. Therefore, in the inorganic encapsulation area CVD, a permeation path MP1 of external air or moisture through the voids may be formed along the side surface of the first sub-power line VSL1. When the first power line VSL includes the plurality of first permeation prevention patterns TP1, the length of the side surface of the first power line VSL may include the sum of the circumferential lengths of the first permeation prevention patterns TP1. Therefore, in a case where the first power line VSL includes the plurality of first permeation prevention patterns TP1, the length of the side surface of the first power line VSL may be longer than the length of the side surface of the first power line VSL in a case where it does not include the plurality of first permeation prevention patterns TP1. Accordingly, due to the plurality of first permeation prevention patterns TP1, the permeation path MP1 of external air or moisture through the voids may be lengthened. Therefore, the plurality of first permeation prevention patterns TP1 may delay or prevent the permeation of external air or moisture. Therefore, even when the width of the inorganic encapsulation area is decreased, it is possible to prevent the organic light-emitting elements of the light-emitting units, which are adjacent to the inorganic encapsulation area, from being damaged by air or moisture.

The plurality of first permeation prevention patterns TP1 may be disposed in the inorganic encapsulation area CVD. Further, the plurality of first permeation prevention patterns TP1 may be disposed in the first non-display area NDA1, the dam area DAMA, and the bank area BNKA, but the disclosure is not limited thereto. The plurality of first permeation prevention patterns TP1 may be omitted from at least one of the first non-display area NDA1, the dam area DAMA, or the bank area BNKA.

Each of the first permeation prevention patterns TP1 may have an elliptical shape in a plan view as shown in FIG. 7, but the disclosure is not limited thereto. Each of the permeation prevention patterns TP1 may have a circular shape or a polygonal shape such as a triangle or a quadrangle in a plan view.

As a length 'a' of each first permeation prevention pattern TP1 in the first direction (X-axis direction) and a length 'b' thereof in the second direction (Y-axis direction) increase, the circumferential length of each first permeation prevention pattern TP1 may increase. Recently, the non-display area NDA has been decreased to widen the display area DA, and thus the width of the inorganic encapsulation area CVD has been decreased. As the width of the inorganic encapsulation area CVD decreases, the number of first permeation prevention patterns TP1 may be decreased. However, when the length 'a' of each first permeation prevention pattern TP1 in the first direction (X-axis direction) and/or the length 'b' thereof in the second direction (Y-axis direction) is increased, the permeation path MP1 of external air or moisture through the voids may not be decreased in the inorganic encapsulation area CVD.

The second power line VDL may be disposed to be spaced apart from the first power line VSL. The second power line VDL may supply a second power voltage, which has a higher potential than the first power voltage, to the display area DA. The second power line VDL may include a third sub-power line VDL1, a fourth sub-power line VDL2, and a fifth sub-power line VDL3, and a plurality of second permeation prevention patterns TP2.

The third sub-power line VDL1 and the fourth sub-power line VDL2 may be disposed in the second direction (Y-axis direction). The third sub-power line VDL1 may be disposed in the dam area DAMA, the inorganic encapsulation area CVD, and the bank area BNKA. The fourth sub-power line VDL2 may be disposed in the first non-display area NDA1 and the dam area DAMA. The third sub-power line VDL1 may be connected to the fourth sub-power line VDL2 through a second power contact hole VDCT1.

The fifth sub-power line VDL3 may be disposed in the first non-display area NDA1. The fifth sub-power line VDL3 may be connected to the fourth sub-power line VDL2 through a third power contact hole VDCT2. Accordingly, the resistance of the second power line VDL may be decreased, so that the second power voltage may be supplied more uniformly regardless of the location of the light-emitting units ('EA3' of FIG. 5) disposed in the display area DA.

In the inorganic encapsulation area CVD, the third sub-power line VDL1 may not be properly covered by the first inorganic encapsulation layer TFE1 and the second inorganic encapsulation layer TFE3 due to the inclination of the side surface of the third sub-power line VDL1. That is, in the inorganic encapsulation area CVD, voids may be generated in the first inorganic encapsulation layer TFE1 and the second inorganic encapsulation layer TFE3 due to the inclination of the side surface of the third sub-power line VDL1. The voids may become a permeation passage of external air or moisture.

The plurality of second permeation prevention patterns TP2 may protrude from one side of the third sub-power line VDL1 in the first direction (X-axis direction). The plurality of second permeation prevention patterns TP2 may be disposed in the second direction (Y-axis direction). The plurality of second permeation prevention patterns TP2 may be disposed to face the plurality of first permeation prevention patterns TP1.

In the inorganic encapsulation area CVD, the voids may be formed along the side surface of the third sub-power line VDL1. Therefore, in the inorganic encapsulation area CVD, a permeation path MP2 of external air or moisture through the voids may be formed along the side surface of the third sub-power line VDL1. When the second power line VDL includes the plurality of second permeation prevention patterns TP2, the length of the side surface of the second power line VDL may include the sum of the circumferential lengths of the second permeation prevention patterns TP2. Therefore, in a case where the second power line VDL includes the plurality of second permeation prevention patterns TP2, the length of the side surface of the second power line VDL may be longer than the length of the side surface of the second power line VDL in a case where it does not include the plurality of second permeation prevention patterns TP2. Accordingly, due to the plurality of second permeation prevention patterns TP2, the permeation path MP2 of external air or moisture through the voids may be lengthened. Therefore, the plurality of second permeation prevention patterns TP2 may delay or prevent the permeation of external air or moisture.

The plurality of second permeation prevention patterns TP2 may be disposed in the inorganic encapsulation area CVD. Further, the plurality of second permeation prevention patterns TP2 may be disposed in the dam area DAMA and the bank area BNKA, but the disclosure is not limited thereto. The plurality of second permeation prevention patterns TP2 may be omitted from at least one of the dam area DAMA or the bank area BNKA.

As shown in FIG. 7, in the inorganic encapsulation area CVD, the first power line VSL includes the plurality of first permeation prevention patterns TP1, and the second power line VDL includes the plurality of second permeation prevention patterns TP2. Therefore, even when voids are formed along the side surface of the first power line VSL in the inorganic encapsulation area CVD, the permeation path MP1 of external air or moisture through the voids may be lengthened. In addition, even when voids are formed along the side surface of the second power line VDL in the inorganic encapsulation area CVD, the permeation path MP2 of external air or moisture through the voids may be lengthened. Therefore, the first permeation prevention patterns TP1 and the second permeation prevention patterns TP2 may delay or prevent the permeation of external air or moisture.

FIG. 8 is a cross-sectional view illustrating an embodiment of the display panel taken along line B-B' of FIG. 7.

Referring to FIG. 8, the first power line VSL may include the first sub-power line VSL1 and the second sub-power line VSL2. The dam DAM may include a first sub-dam DAM1, a second sub-dam DAM2, a third sub-dam DAM3, and a fourth sub-dam DAM4. The dam DAM may be disposed in the dam area DAMA. FIG. 8 illustrates that one dam DAM is disposed in the dam area DAMA, but the disclosure is not limited thereto. A plurality of dams DAM may be disposed in the dam area DAMA. A valley structure VS may be a structure for forming a valley VAL between the valley structure VS and the first organic layer 160, and may be disposed in the first non-display area NDA1. The valley structure VS may include a first valley structure VS1 and a second valley structure VS2.

Since the dam DAM prevents an overflow of the organic encapsulation layer TFE2 of the encapsulation layer ('TFEL' of FIG. 5), a remaining layer of the organic encapsulation layer, which has overflowed beyond the valley structure VS, may remain between the valley structure VS and the dam DAM.

The bank BNK may include a first sub-bank BNK1, a second sub-bank BNK2, a third sub-bank BNK3, and a fourth sub-bank BNK4.

The second sub-power line VSL2 may be disposed on the second inter-insulating layer 142. The second sub-power line VSL2 may be disposed in the first non-display area NDA1 and the dam area DAMA. The second sub-power line VSL2 may overlap the dam DAM and the valley structure VS in the third direction (Z-axis direction). The second sub-power line VSL2 and the first anode connection electrode ANDE1 may include the same material, and may be disposed in the same layer.

The first sub-dam DAM1 may be disposed on the second sub-power line VSL2. The first sub-bank BNK1 may be disposed on the inter-insulating layer 142. The first sub-dam DAM1 and the first sub-bank BNK1 may include the same material as that of the first organic layer 160 and may be disposed in the same layer.

The first sub-power line VSL1 may be disposed on the first organic layer 160, the first sub-dam DAM1, and the first sub-bank BNK1. The first sub-power line VSL1 may be connected to the second sub-power line VSL2 through the first power contact hole VSCT. The first power contact hole VSCT may be defined in the dam area DAMA and the first non-display area NDA1. The first sub-power line VSL1 and the second anode connection electrode ANDE2 may include the same material and may be disposed in the same layer.

The second organic layer 161, the second sub-dam DAM2, the first valley structure VS1, and the second sub-bank BNK2 may be disposed on the first sub-power line VSL1. The second sub-dam DAM2, the first valley structure VS1, and the second sub-bank BNK2 may include the same material as that of the second organic layer 161 and may be disposed in the same layer.

The thicknesses of the second sub-dam DAM2 and the second sub-bank BNK2 may be smaller than the thicknesses of the first valley structure VS1 and the second organic layer 161. The first valley structure VS1 may be connected to the second organic layer 161. A thickness of a connecting portion, which connects the first valley structure VS1 to the second organic layer 161, may be smaller than the thicknesses of the first valley structure VS1 and the second organic layer 161.

The third sub-dam DAM3 may be disposed on the second sub-dam DAM2, the second valley structure VS2 may be disposed on the first valley structure VS1, and the third sub-bank BNK3 may be disposed on the second sub-bank BNK2. The third sub-dam DAM3, the second valley structure VS2, and the third sub-bank BNK3 may include the same material as that of the light-emitting unit defining layer 180 and may be disposed in the same layer.

The third sub-dam DAM3 may cover the second sub-dam DAM2. In an embodiment, the third sub-dam DAM3 may be disposed on the top surface and the side surfaces of the second sub-dam DAM2. Further, the second valley structure VS2 may cover the first valley structure VS1. In an embodiment, the second valley structure VS2 may be disposed on the top surface and the side surfaces of the first valley structure VS 1, for example. Further, the third sub-bank BNK3 may cover the second sub-bank BNK2. In an embodiment, the third sub-bank BNK3 may be disposed on the top surface and the side surfaces of the second sub-bank BNK2, for example.

The fourth sub-dam DAM4 may be disposed on the third sub-dam DAM3, and the fourth sub-bank BNK4 may be disposed on the third sub-bank BNK3. The fourth sub-dam DAM4 and the fourth sub-bank BNK4 may include the same material and may be disposed in the same layer. The fourth sub-dam DAM4 and the fourth sub-bank BNK4 may be structures for supporting a mask when the display panel 100 is manufactured. The fourth sub-dam DAM4 and the fourth sub-bank BNK4 may allow the mask to be stably supported without sagging. The fourth sub-dam DAM4 may be omitted.

The first inorganic encapsulation layer TFE1 may be disposed in the first non-display area NDA1, the dam area DAMA, the inorganic encapsulation area CVD, and the bank area BNKA. The first inorganic encapsulation layer TFE1 may be disposed on the light-emitting unit defining layer 180, the valley structure VS, the dam DAM, the first sub-power line VSL1, and the bank BNK. The organic encapsulation layer TFE2 may be disposed in the first non-display area NDA1. Since the organic encapsulation layer TFE2 is not able to cross the dam DAM and the valley structure VS, the first inorganic encapsulation layer TFE1 may contact the second inorganic encapsulation layer TFE3 in the inorganic encapsulation area CVD. Accordingly, an inorganic encapsulation structure may be formed in the inorganic encapsulation area CVD. The second inorganic encapsulation layer TFE3 may be disposed in the first non-display area NDA1, the dam area DAMA, the inorganic encapsulation area CVD, and the bank area BNKA.

FIG. 9 is a cross-sectional view illustrating an embodiment of the display panel taken along line C-C' of FIG. 7.

Referring to FIG. 9, the second power line VDL may include the third sub-power line VDL1, the fourth sub-power line VDL2, and the fifth sub-power line VDL3.

The fourth sub-power line VDL2 may be disposed on the second inter-insulating layer 142. The fourth sub-power line VDL2 may be disposed in the first non-display area NDA1 and the dam area DAMA. The fourth sub-power line VDL2 may overlap the dam DAM and the valley structure VS in the third direction (Z-axis direction). The fourth sub-power line VDL2 and the second sub-power line VSL2 may include the same material, and may be disposed in the same layer.

The third sub-power line VDL1 may be disposed on the first sub-dam DAM1 and the first sub-bank BNK1. The third sub-power line VDL1 may be connected to the fourth sub-power line VDL2 through the second power contact hole VDCT1. The second power contact hole VDCT1 may be defined in the dam area DAMA.

The fifth sub-power line VDL3 may be disposed on the first sub-dam DAM1 and the first organic layer 160. The fifth sub-power line VDL3 may be connected to the fourth sub-power line VDL2 through the third power contact hole VDCT2. The third power contact hole VDCT2 may be defined in the first non-display area NDA1.

The third sub-power line VDL1 and the fifth sub-power line VDL3 may include the same material as that of the first sub-power line VSL1 and may be disposed in the same layer.

The second sub-dam DAM2 and the second sub-bank BNK2 may be disposed on the third sub-power line VDL 1. The first valley structure VS1 and the second organic layer 161 may be disposed on the fifth sub-power line VDL3.

In addition, a description of the dam DAM, the valley structure VS, the bank BNK, and the encapsulation layer TFEL is substantially the same as the description made in conjunction with FIG. 8, and thus the description thereof will be omitted.

FIG. 10 is a cross-sectional view illustrating an embodiment of a display panel taken along line B-B' of FIG. 7.

Referring to FIG. 10, the dam area DAMA may include the plurality of dams DAM. Further, a description of the first power line VSL, the light-emitting unit defining layer 180, the valley structure VS, the bank BNK, and the encapsulation layer TFEL is substantially the same as the description made in conjunction with FIG. 8, and thus the description thereof will be omitted.

Referring to FIG. 10, a first dam DAM and a second dam DAMS may be disposed in the dam area DAMA. The first dam DAM may be disposed more outward than the second dam DAMS.

The first dam DAM may include the first sub-dam DAM1, the second sub-dam DAM2, the third sub-dam DAM3, and the fourth sub-dam DAM4. The second dam DAMS may include a first sub-dam DAMS 1 and a second sub-dam DAMS2. As such, the first dam DAM may be higher than the second dam DAMS, but the disclosure is not limited thereto. In an embodiment, the second dam DAMS may be higher than the first dam DAM, for example. In an alternative embodiment, the first dam DAM may be formed at the same height as a height of the second dam DAMS.

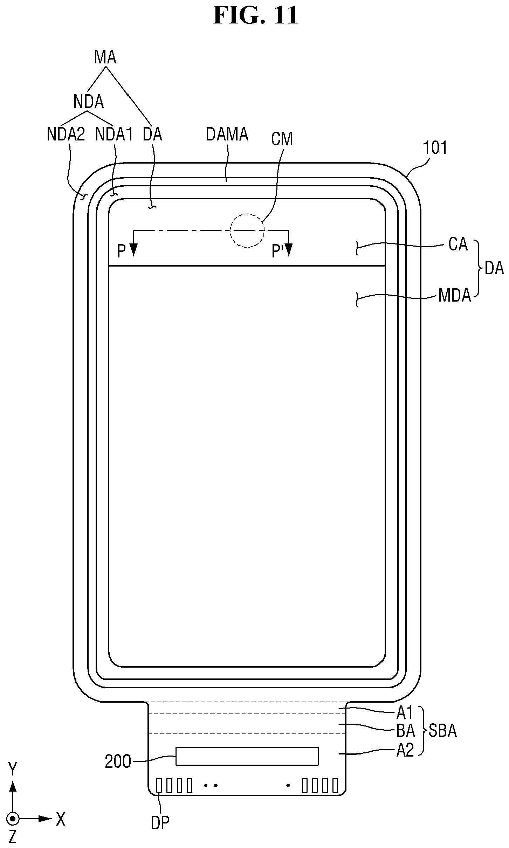

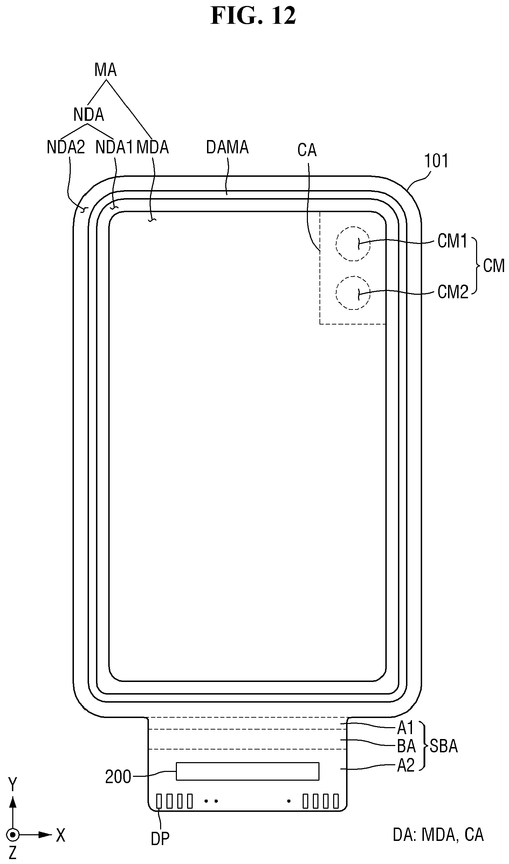

FIG. 11 is a plan view illustrating an embodiment of a display device. FIG. 12 is a plan view illustrating an embodiment of a display device.

As illustrated in FIGS. 11 and 12, a display panel 101 may include the main region MA and the sub-region SBA.

The main region MA may include a display area DA displaying an image and a non-display area NDA that is a peripheral area of the display area DA. The display area DA may occupy most of the main region MA. The display area DA may be disposed at the center of the main region MA.

The display area DA includes a main display area MDA and a component area CA. Both the main display area MDA and the component area CA may be areas in which images are displayed. The component area CA may be an area in which pixels displaying an image are disposed and a component CM such as a sensor and a camera using visible light, infrared light, or sound is disposed at the lower portion of the component area CA. In an embodiment, the component area CA may be disposed inside the main display area MDA while being surrounded by the main display area MDA. In addition, the component area CA may be provided in a circular shape, and a plurality of component areas CA may be provided. When the plurality of component areas CA is provided, the component areas CA may be arranged side by side in the Y-axis direction. In another embodiment, the component areas CA may be disposed side by side in the X-axis direction.

The component area CA may be disposed at the upper center of the display area DA as shown in FIG. 11. In an alternative embodiment, the display area CA may be disposed at the upper right side of the display area DA as shown in FIG. 12. In this arrangement, when an imaging device such as a camera is disposed to correspond to the component area CA, the gaze of a user, who makes a self-photography or video call, may be naturally captured.

The component area CA may include a first component area and a second component area that are arranged side by side in the Y-axis direction. In an embodiment, a first camera CM1 may be provided to overlap the first component area, and a second camera CM2 may be provided to overlap the second component area, for example, but the disclosure is not limited thereto.

The component area CA may be an area having higher light transmittance and/or sound transmittance than that of the main display area MDA. In an embodiment, when light passes through the component area CA, the light transmittance may be about 25% or more, about 30% or more, more preferably about 50% or more, about 75% or more, about 80% or more, about 85% or more, or about 90% or more. The component area CA may be disposed anywhere in the main display area MDA. In an embodiment, the component area CA may be disposed at the upper center of the display area DA as shown in FIG. 11, for example. In an alternative embodiment, the component area CA may be disposed at the upper right side of the display area DA as shown in FIG. 12.

One or more components CM are disposed to overlap the component area CA. The component CM is not limited to a proximity sensor, an illuminance sensor, an iris sensor, and a camera, and various sensors, which will be described later, may be disposed as the component CM.

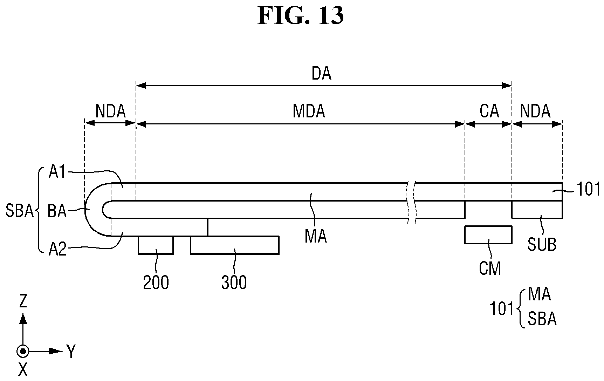

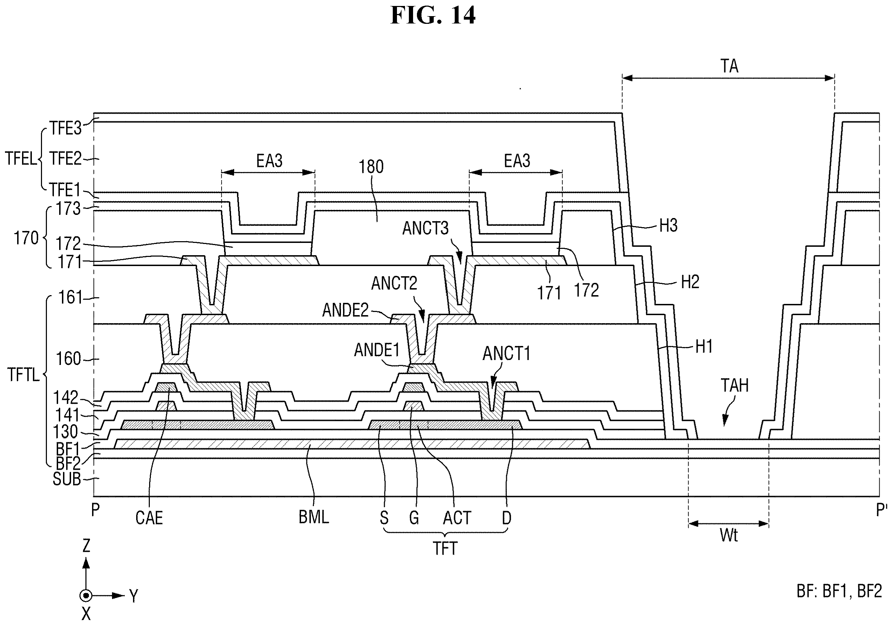

FIG. 13 is a side view illustrating a display device. FIG. 14 is a cross-sectional view illustrating an embodiment of a display panel taken along line P-P' of FIG. 11.

Referring to FIGS. 13 and 14, the substrate SUB may include an insulating material such as polymer resin or glass. In an embodiment, the substrate SUB may include polyimide. In this case, the substrate SUB may be a flexible substrate which may be bent, folded or rolled.

A thin film transistor layer TFTL including thin film transistors TFT may be disposed on the substrate SUB. The thin film transistor layer TFTL may include thin film transistors TFT, a capacitor, a first anode connection electrode ANDE1, a second anode connection electrode ANDE2, a buffer layer BF, a gate insulating layer 130, a first inter-insulating layer 141, a second inter-insulating layer 142, a first organic layer 160, and a second organic layer 161.

A transmission area TA may be disposed on the substrate SUB on which the thin film transistor TFT is not disposed. The transmission area TA may be an area, through which light/signal emitted from the component CM that is disposed to correspond to the component area CA or light/signal incident the component CM, is transmitted.

A lower metal layer BML may be disposed in a region of the component area CA, in which the thin film transistor TFT is disposed. The lower metal layer BML may be disposed under the thin film transistor TFT to correspond thereto. In an embodiment, the lower metal layer BML may be disposed between the thin film transistor TFT and the substrate SUB, for example. The lower metal layer BML may block external light from reaching the thin film transistor TFT. In some embodiments, a constant voltage or signal may be applied to the lower metal layer BML to prevent damage to a pixel circuit due to electrostatic discharge. A plurality of lower metal layers BML may be disposed in the component area CA, and different voltages may be applied to the respective lower metal layers BML in some cases. One lower metal layer BML in which a hole corresponding to the transmission area TA is defined may be disposed in the component area CA.

A display element layer may be covered by the thin film encapsulation layer TFEL or covered by an encapsulation substrate. In some embodiments, the thin film encapsulation layer TFEL may include at least one inorganic encapsulation layer and at least one organic encapsulation layer as shown in FIG. 14. In an embodiment, the thin film encapsulation layer TFEL may include the first and second inorganic encapsulation layers TFE1 and TFE3 and the organic encapsulation layer TFE2 therebetween.

In some embodiments, the thin film encapsulation layer TFEL may be disposed to be opposite to the substrate SUB with the thin film transistor layer TFTL interposed therebetween, as shown in FIG. 14.

The non-display area NDA may be an area outside the display area DA. The non-display area NDA may be disposed to surround the display area DA. The non-display area NDA may be disposed adjacent to the display area DA. The non-display area NDA may include the dam area DAMA. Since the non-display area NDA is the same as described with reference to FIGS. 2 to 10, a detailed description thereof will be omitted.

The sub-region SBA may protrude in the second direction (Y-axis direction) from one side of the main region MA. The length of the sub-region SBA in the second direction (Y-axis direction) may be less than the length of the main region MA in the second direction (Y-axis direction). The length of the sub-region SBA in the first direction (X-axis direction) may be substantially equal to or less than the length of the main region MA in the first direction (X-axis direction). The sub-region SBA may be bent so as to be placed on the bottom surface of the display panel 101. In this case, the sub-region SBA may overlap the main region MA in the third direction (Z-axis direction).

The sub-region SBA may include a first region A1, a second region A2, and a bending area BA.

The first region A1 is a region protruding from one side of the main region MA in the second direction (Y-axis direction). One side of the first region A1 may contact the non-display area NDA of the main region MA, and the other side of the first region A1 may contact the bending area BA.

The second region A2 is an area on which display pads DP and the display driving circuit 200 are disposed. The display driving circuit 200 may be attached to driving pads of the second region A2 using a low-resistance high-reliability material such as SAP or an anisotropic conductive film. The circuit board 300 may be attached to the display pads DP of the second region A2 using a low-resistance high-reliability material such as SAP or an anisotropic conductive film. One side of the second region A2 may contact the bending area BA.

The bending area BA is an area being bent. When the bending area BA is bent, the second region A2 may be disposed under the first region A1 and under the main region MA. The bending area BA may be disposed between the first region A1 and the second region A2. One side of the bending area BA may contact the first region A1, and the other side of the bending area BA may contact the second region A2. In an embodiment, a support layer PB may be disposed on a lower surface of the display panel 101.

Referring to FIG. 14, auxiliary pixels and the transmission area TA are disposed in the component area CA.

Hereinafter, a stacked structure of the components included in the component area CA will be described. The substrate SUB, the buffer layer BF, the thin film transistor layer TFTL, and the encapsulation layer TFEL may be provided while being stacked in the component area CA.

The substrate SUB may include an insulating material such as polymer resin and glass. In an embodiment, the substrate SUB may include polyimide, for example. In this case, the substrate SUB may be a flexible substrate which may be bent, folded or rolled.

A thin film transistor layer TFTL including thin film transistors TFT may be disposed on the substrate SUB. The thin film transistor layer TFTL may include thin film transistors TFT, a capacitor, a first anode connection electrode ANDE1, a second anode connection electrode ANDE2, a buffer layer BF, a gate insulating layer 130, a first inter-insulating layer 141, a second inter-insulating layer 142, a first organic layer 160, and a second organic layer 161.

The buffer layer BF may be disposed on the substrate SUB. The buffer layer BF may include a silicon nitride layer, a silicon oxynitride layer, a silicon oxide layer, a titanium oxide layer, or an aluminium oxide layer.

The thin film transistors TFT may be disposed on the buffer layer BF. The buffer layer BF may be provided in which the first buffer layer BF1 and the second buffer layer BF2 are stacked.

The lower metal layer BML may be disposed between the first buffer layer BF1 and the second buffer layer BF2 in the component area CA. In another embodiment, the lower metal layer BML may be disposed between the substrate SUB and the first buffer layer BF1. The lower metal layer BML may be disposed under the auxiliary pixels to prevent deterioration of properties of the auxiliary thin film transistor TFT by light emitted from a component or the like. Further, the lower metal layer BML may prevent light, which has been emitted from to the component or the like or is directed thereto, from being diffracted through a narrow gap between the lines connected to the auxiliary pixels. The lower metal layer BML does not exist in the transmission area TA.

Further, the lower metal layer BML may be connected to a line (not shown) arranged in another layer through a contact hole. In an embodiment, the lower metal layer BML may receive a driving voltage or a scan signal, for example. As the lower metal layer BML receives a constant voltage or a signal, the probability of occurrence of an electrostatic discharge may be significantly decreased. The lower metal layer BML may include aluminium (Al), platinum (Pt), palladium (Pd), silver (Ag), magnesium (Mg), gold (Au), neodymium (Nd), iridium (Ir), chromium (Cr), lithium (Li), calcium (Ca), molybdenum (Mo), titanium (Ti), tungsten (W), and/or copper (Cu). The lower metal layer BML may be provided as a single layer or multiple layers including the above-described materials.

The thin film transistor TFT may include an active layer ACT, a gate electrode G, a source electrode S, and a drain electrode D. The active layer ACT may include a silicon semiconductor such as polycrystalline silicon, monocrystalline silicon, low-temperature polycrystalline silicon, and amorphous silicon. The source electrode S and the drain electrode D may be formed by doping a silicon semiconductor with ions or impurities to have conductivity. The active layer ACT may overlap the gate electrode G in the third direction (Z-axis direction) that is the thickness direction of the substrate SUB, and the source electrode S and the drain electrode D may not overlap the gate electrode G in the third direction (Z-axis direction).

The gate insulating layer 130 may be disposed on the active layer ACT, the source electrode S, and the drain electrode D constituting the thin film transistor TFT. The gate insulating layer 130 may include an inorganic layer, e.g., a silicon nitride layer, a silicon oxynitride layer, a silicon oxide layer, a titanium oxide layer, or an aluminium oxide layer.

The gate electrode G of the thin film transistor TFT may be arranged on the gate insulating layer 130. The gate electrode G may be formed as a single layer or multiple layers including any one of molybdenum (Mo), aluminium (Al), chromium (Cr), gold (Au), titanium (Ti), nickel (Ni), neodymium (Nd) and copper (Cu) or an alloy thereof.

The first inter-insulating layer 141 may be disposed on the gate electrode G. The first inter-insulating layer 141 may include an inorganic layer, e.g., a silicon nitride layer, a silicon oxynitride layer, a silicon oxide layer, a titanium oxide layer, or an aluminium oxide layer.

A capacitor electrode CAE may be disposed on the first inter-insulating layer 141. The capacitor electrode CAE may overlap the gate electrode G in the third direction (Z-axis direction). Since the first inter-insulating layer 141 has a predetermined dielectric constant, a capacitor may be formed by the capacitor electrode CAE, the gate electrode G, and the first inter-insulating layer 141 disposed between the capacitor electrode CAE and the gate electrode G. The capacitor electrode CAE may be formed as a single layer or multiple layers including any one of molybdenum (Mo), aluminium (Al), chromium (Cr), gold (Au), titanium (Ti), nickel (Ni), neodymium (Nd) and copper (Cu) or an alloy thereof.

A second inter-insulating layer 142 may be disposed on the capacitor electrode CAE. The second inter-insulating layer 142 may include an inorganic layer, e.g., a silicon nitride layer, a silicon oxynitride layer, a silicon oxide layer, a titanium oxide layer, or an aluminium oxide layer. The second inter-insulating layer 142 may include a plurality of inorganic layers, and may be larger in thickness than the first inter-insulating layer 141 in the third direction (Z-axis direction).

The first anode connection electrode ANDE1 may be disposed on the second inter-insulating layer 142. The first anode connection electrode ANDE1 may be connected to the drain electrode D via the first anode contact hole ANCT1 penetrating the first and second inter-insulating layers 141 and 142 and the gate insulating layer 130 to expose the drain electrode D of the thin film transistor TFT. The first anode connection electrode ANDE1 may be formed as a single layer or multiple layers including any one of molybdenum (Mo), aluminium (Al), chromium (Cr), gold (Au), titanium (Ti), nickel (Ni), neodymium (Nd) and copper (Cu), or an alloy thereof.

The first organic layer 160 for planarization may be disposed on the first anode connection electrode ANDE1. The first organic layer 160 may include an organic layer such as acryl resin, epoxy resin, phenolic resin, polyamide resin, polyimide resin or the like.

A first hole H1 corresponding to the transmission area TA of the buffer layer BF may be defined in the first organic layer 160. In this case, the meaning that the first hole H1 corresponds to the transmission area TA of the buffer layer BF may be understood as that the first hole H1 overlaps the transmission area TA of the buffer layer BF.

The first hole H1 may expose partially the top surface of the buffer layer BF or the substrate SUB. The first hole H1 may be defined by overlapping an opening of the gate insulating layer 130, an opening of the first inter-insulating layer 141, and an opening of the second inter-insulating layer 142 that correspond to the transmission area TA. These openings may be respectively defined through separate processes or may be simultaneously defined through the same process. When these openings are defined by separate processes, the inner surface of the first hole H1 may not be smooth and may have a stepped portion such as a form of a staircase.

In an alternative embodiment, the gate insulating layer 130, the first inter-insulating layer 141, and the second inter-insulating layer 142 may define a groove instead of the first hole H1 that exposes the buffer layer BF. In an alternative embodiment, the gate insulating layer 130, the first inter-insulating layer 141, and the second inter-insulating layer 142 may not define the first hole H1 or the groove corresponding to the transmission area TA. The gate insulating layer 130, the first inter-insulating layer 141, and the second inter-insulating layer 142 have an inorganic insulating material having an excellent light transmittance. Therefore, they have sufficient transmittance even when they do not define a hole or a groove corresponding to the transmission area TA, and thus they may allow the component CM to transmit/receive a sufficient amount of light.

The second anode connection electrode ANDE2 may be disposed on the first organic layer 160. The second anode connection electrode ANDE2 may be connected to the first anode connection electrode ANDE1 via the second anode contact hole ANCT2 penetrating the first organic layer 160 to expose the first anode connection electrode ANDE1. The second anode connection electrode ANDE2 may be formed as a single layer or multiple layers including any one of molybdenum (Mo), aluminium (Al), chromium (Cr), gold (Au), titanium (Ti), nickel (Ni), neodymium (Nd) and copper (Cu), or an alloy thereof.

The second organic layer 161 may be disposed on the second anode connection electrode ANDE2. The second organic layer 161 may include an organic layer such as acryl resin, epoxy resin, phenolic resin, polyamide resin, polyimide resin or the like.

A second hole H2 corresponding to the transmission area TA may be defined in the second organic layer 161. The second hole H2 may overlap the first hole H1. FIG. 14 illustrates that the second hole H2 is larger than the first hole H1. In another embodiment, the second organic layer 161 may be provided to cover the edge of the first hole H1, and thus the second hole H2 may have a size smaller than the size of the first hole H1.

The pixel electrode 171 may be formed on the second organic layer 161. The pixel electrode 171 may be connected to the second anode connection electrode ANDE2 via the third anode contact hole ANCT3 penetrating the second organic layer 161 to expose the second anode connection electrode ANDE2.

In a top emission structure in which light is emitted toward the common electrode 173 when viewed with respect to the light-emitting layer 172, the pixel electrode 171 may include a metal material having high reflectivity such as a stacked structure (Ti/Al/Ti) of aluminium and titanium, a stacked structure (ITO/Al/ITO) of aluminium and ITO, an APC alloy, and a stacked structure (ITO/APC/ITO) of an APC alloy and ITO. The APC alloy is an alloy of silver (Ag), palladium (Pd) and copper (Cu).

The light-emitting unit defining layer 180 may partition the pixel electrode 171 on the second organic layer 161 in order for the function of defining the light-emitting units EA3. The light-emitting unit defining layer 180 may cover the edge of the pixel electrode 171. The light-emitting unit defining layer 180 may include an organic layer such as acryl resin, epoxy resin, phenolic resin, polyamide resin, polyimide resin or the like.

The light-emitting unit defining layer 180 may define a third hole H3 in the transmission area TA. The third hole H3 may overlap the first hole H1 and the second hole H2. The light transmittance in the transmission area TA may be increased by the first to third holes H1 to H3. Although FIG. 14 shows that the buffer layer BF is continuously disposed to correspond to the transmission area TA, a hole may be defined in the buffer layer BF in the transmission area TA. A part of the common electrode 173, which will be described later, may be disposed on the inner surface of the first to third holes H1 to H3.

The meaning that a component hole TAH corresponds to the transmission area TA may be understood as that the component hole TAH overlaps the transmission area TA. In this case, the component hole TAH may be provided while having a size smaller than the size of the first hole H1 defined in the first organic layer 160.

To this end, FIG. 14 illustrates that a width Wt of the component hole TAH is smaller than the width of the first hole H1. In this case, the size of the component hole TAH may be defined as a size of an opening that has the smallest size among the openings constituting the component hole TAH.

The size of the first hole H1 may also be defined as a size of an opening that has the smallest size among the openings constituting the first hole H1.

Due to the component hole TAH, a part of the common electrode 173 may not exist in the transmission area TA, and thus the light transmittance in the transmission area TA may be significantly increased. The common electrode 173 having the component hole TAH may be formed by various methods. In an embodiment, after a material for forming the common electrode 173 is formed on the entire surface of the substrate SUB, a part thereof corresponding to the transmission area TA is removed by a laser lift-off ("LLO") method, so that the common electrode 173 defining the component hole TAH may be formed. In another embodiment, the common electrode 173 defining the component hole TAH may be formed by a metal self-patterning ("MSP") method. In another embodiment, the common electrode 173 defining the component hole TAH may be formed by depositing the common electrode 173 using a fine metal mask ("FMM").

Each of the light-emitting units EA3 is an area in which the pixel electrode 171, the light-emitting layer 172, and the common electrode 173 are sequentially stacked such that the holes from the pixel electrode 171 and the electrons from the common electrode 173 are combined with each other to emit light.

The light-emitting layer 172 is formed on the pixel electrode 171 and the light-emitting unit defining layer 180. The light-emitting layer 172 may include an organic material to emit light in a predetermined color. In an embodiment, the light-emitting layer 172 includes a hole transporting layer, an organic material layer, and an electron transporting layer, for example.

The common electrode 173 is formed on the light-emitting layer 172. The common electrode 173 may cover the light-emitting layer 172. The common electrode 173 may be a common layer formed in common on all light-emitting units EA3. A capping layer may be formed on the common electrode 173.

In the top emission structure, the common electrode 173 may include transparent conductive oxide ("TCO") such as indium tin oxide ("ITO") and indium zinc oxide ("IZO") capable of transmitting light or a semi-transmissive conductive material such as magnesium (Mg), silver (Ag), or an alloy of magnesium (Mg) and silver (Ag). When the common electrode 173 includes a semi-transmissive conductive material, the light emission efficiency may be increased due to a micro-cavity effect.

The encapsulation layer TFEL may be disposed on the common electrode 173. The encapsulation layer TFEL includes at least one inorganic layer to prevent oxygen or moisture from permeating into the light-emitting element layer 170. In addition, the encapsulation layer TFEL includes at least one organic layer to protect the light-emitting element layer 170 from foreign substances such as dust. In an embodiment, the encapsulation layer TFEL may include a first inorganic encapsulation layer TFE1, an organic encapsulation layer TFE2, and a second inorganic encapsulation layer TFE3, for example.

The first inorganic encapsulation layer TFE1 may be disposed on the common electrode 173, the organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may include multiple layers in which one or more inorganic layers of a silicon nitride layer, a silicon oxynitride layer, a silicon oxide layer, a titanium oxide layer and an aluminium oxide layer are alternately stacked. The organic encapsulation layer TFE2 may include acryl resin, epoxy resin, phenolic resin, polyamide resin, polyimide resin or the like.

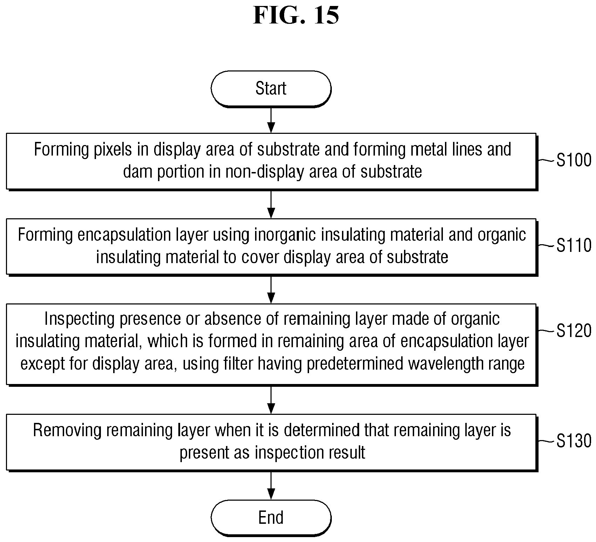

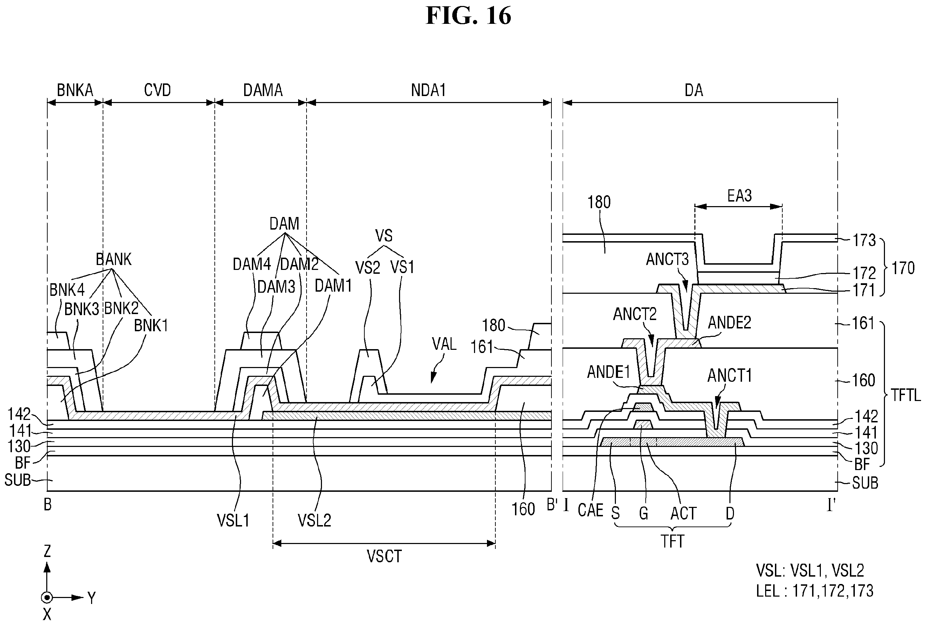

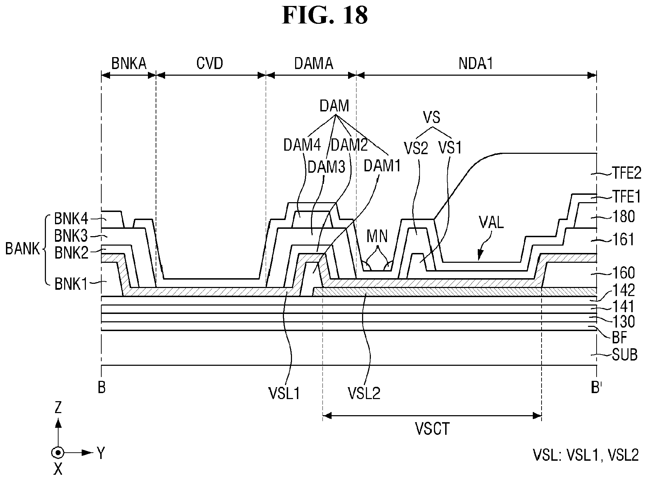

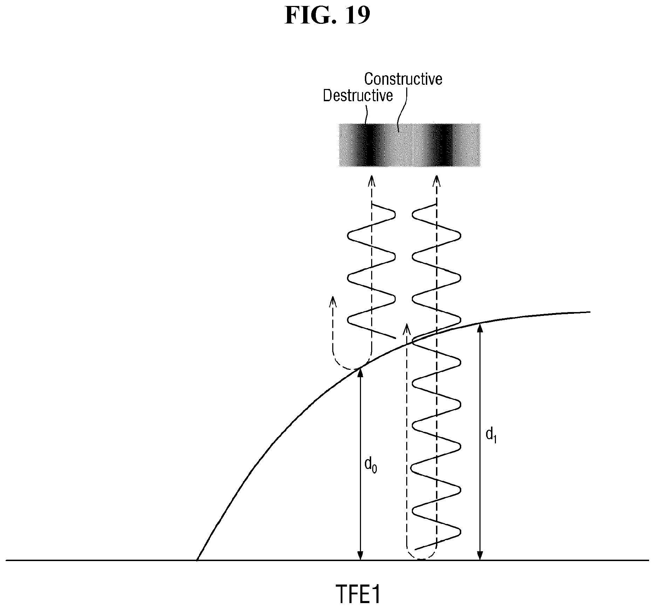

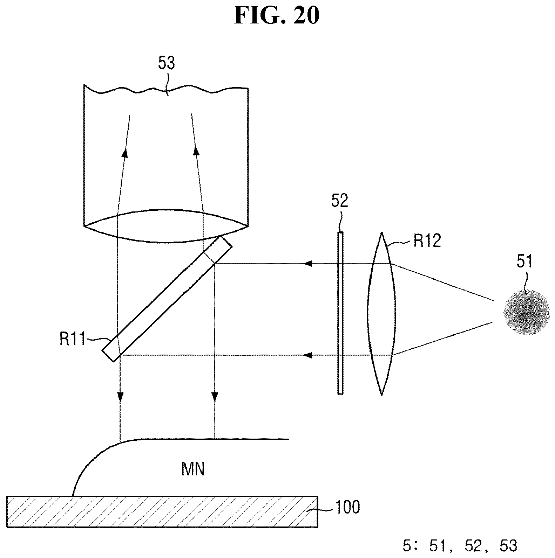

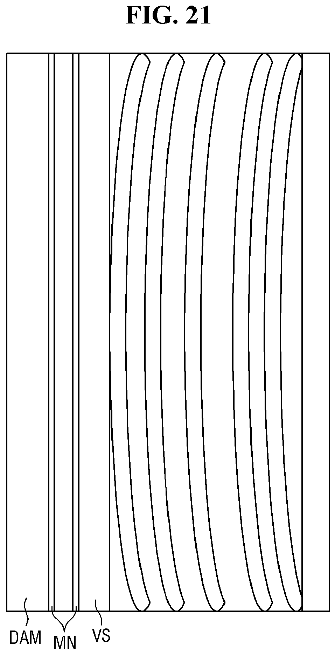

FIG. 15 is a flowchart showing an embodiment of a manufacturing method of a display panel according to the disclosure. FIGS. 16 and 18 are cross-sectional views illustrating an embodiment of a manufacturing method of a display panel according to the disclosure. FIG. 19 is a diagram for explaining an embodiment of a formation of interference fringes. FIG. 20 is a diagram for explaining an embodiment of an inspection device. FIG. 21 is a diagram illustrating an embodiment of interference fringes formed by an organic encapsulation layer corresponding to the dam area DAMA and the first non-display area NDA1 of FIG. 18.

FIGS. 15 to 20 illustrate the manufacturing method of the display panel described with reference to FIGS. 1 to 10, and therefore the same components are denoted by the same reference numerals, and a description thereof will be omitted.

Referring to FIG. 15, the manufacturing method of the display panel may include forming pixels in the display area DA of the substrate SUB and forming the first and second sub-power lines (also referred to as metal lines) VSL1 and VSL2 and a dam portion DAM in the non-display area NDA (*e.g.* the first non-display area NDA1, the dam area DAMA, the inorganic encapsulation area CVD, and the bank area BNKA) of the substrate SUB (operation S100), forming an encapsulation layer using an inorganic insulating material and an organic insulating material to cover the display area DA of the substrate SUB (operation S1 10), and inspecting the presence or absence of a remaining layer including the organic insulating material, which is formed in the remaining area of the encapsulation layer except for the display area, using a filter having a predetermined wavelength range (operation S120). When it is determined that the remaining layer is present as the inspection result, the manufacturing method of the display panel may further include removing the remaining layer (operation S130).

In operation S100 of forming the pixels in the display area DA of the substrate SUB and forming the metal lines VSL1 and VSL2 and the dam portion DAM in the non-display area NDA of the substrate SUB, the buffer layer BF is first formed in the display area DA and the non-display area NDA of the substrate SUB. The buffer layer BF may include a plurality of inorganic layers that are alternately stacked. In an embodiment, the buffer layer BF may include a multilayer in which one or more inorganic layers of a silicon oxide (SiOx) layer, a silicon nitride (SiNx) layer and a silicon oxynitride (SiON) layer are alternately stacked, for example. The buffer layer BF may be formed by a chemical vapor deposition method. The active layer ACT of a thin film transistor is formed on the buffer layer BF of the display area DA. Specifically, an active metal layer is formed on the entire surface of the buffer layer BF by a sputtering method or a metal organic chemical vapor deposition method. Then, the active metal layer is patterned by a mask process using a photoresist pattern to form the active layer ACT. The active layer ACT may include a silicon-based semiconductor material or an oxide-based semiconductor material.

Thereafter, the source electrode S and the drain electrode D of the thin film transistor are formed on the buffer layer BF. Specifically, a second metal layer is formed on the entire surface of the buffer layer BF by the sputtering method or the metal organic chemical vapor deposition method. Subsequently, the source electrode S and the drain electrode D are formed by patterning the second metal layer by a mask process using a photoresist pattern.

Then, the gate insulating layer 130, which is an inorganic layer, is formed on the source electrode S, the drain electrode D, and the active layer ACT. Thereafter, the gate electrode G of the thin film transistor TFT is formed on the gate insulating layer 130. In an embodiment, a first metal layer is formed on the entire surface of the gate insulating layer 130 by the sputtering method or the metal organic chemical vapor deposition method, for example. Then, the gate electrode G is formed by patterning the first metal layer by a mask process using a photoresist pattern. The gate electrode G may be formed as a single layer or multiple layers including any one of molybdenum (Mo), aluminium (Al), chromium (Cr), gold (Au), titanium (Ti), nickel (Ni), neodymium (Nd) and copper (Cu) or an alloy thereof.

Subsequently, the first inter-insulating layer 141 is formed on the gate electrode G. The first inter-insulating layer 141 may include an inorganic layer such as a silicon oxide (SiOx) layer and a silicon nitride (SiNx) layer, or a multilayer thereof.

The capacitor electrode CAE is formed on the first inter-insulating layer 141 through patterning. The second inter-insulating layer 142 is formed on the capacitor electrode CAE. The second inter-insulating layer 142 may include an inorganic layer such as a silicon oxide (SiOx) layer and a silicon nitride (SiNx) layer, or a multilayer thereof.

The first anode connection electrode ANDE1 is formed on the second inter-insulating layer 142. In this case, the first anode contact hole ANCT1 may penetrate the first inter-insulating layer 141, the second inter-insulating layer 142, and the gate insulating layer 130 and expose the drain electrode D of the thin film transistor TFT, so that the first anode connection electrode ANDE1 may be connected to the drain electrode D through the first anode contact hole ANCT1.

A conductive layer is deposited in the non-display area NDA of the substrate SUB and then patterned to form the metal lines VSL1 and VSL2.

In an embodiment, the first organic layer 160 is formed on the first anode connection electrode ANDE1. The first organic layer 160 forms the first sub-dam DAM1 to cover a part of the metal line VSL2 in the first non-display area NDA1, and forms the first sub-bank BNK1 on the second inter-insulating layer 142 in the bank area BNKA. In the first non-display area NDA1, the metal line VSL1 is formed on the second inter-insulating layer 142 by patterning. At this time, a plurality of permeation prevention patterns may be formed at the metal lines VSL1 and VSL2 to protrude outward. The plurality of permeation prevention patterns may have a circular shape, an elliptic shape, or a polygonal shape in a plan view.

Then, the second anode connection electrode ANDE2 is formed on the first organic layer 160. In this case, the second anode contact hole ANCT2 penetrates the first organic layer 160 and expose the first anode connection electrode ANDE1, so that the second anode connection electrode ANDE2 may be connected to the first anode connection electrode ANDE1 through the second anode contact hole ANCT2.

The second organic layer 161 may be disposed on the second anode connection electrode ANDE2 of the display area DA. The valley structure VS1, the second sub-dam DAM2, and the second sub-bank BNK2 are formed on the metal lines of the non-display area NDA.

The pixel electrode 171 is formed on the second organic layer 161. At this time, the third anode contact hole ANCT3 of the pixel electrode 171 penetrates the second organic layer 161 and expose the second anode connection electrode ANDE2. The pixel electrode 171 may be connected to the second anode connection electrode ANDE2 through the third anode contact hole ANCT3.

Thereafter, the light-emitting layer 172 is arranged on the pixel electrode 171, and the light-emitting unit defining layer 180 is formed on the second organic layer 161 where the light-emitting layer 172 is not disposed. In the non-display area NDA, the second valley structure VS2 is formed on the first valley structure VS 1, the third sub-dam DAM3 is formed on the second sub-dam DAM2, and the third sub-bank BNK3 is formed on the second sub-bank BNK2.

In the non-display area NDA, the fourth sub-dam DAM4 may be formed on the third sub-dam DAM3, and the fourth sub-bank BNK4 may be formed on the third sub-bank BNK3. In this case, the dam DAM may include at least one side surface that is inclined less than 90 degrees through an exposure process using a halftone mask or a slit mask. More specifically, a full-tone mask is disposed in a region where the top surface of the dam DAM is to be formed, a halftone mask or a slit mask is disposed in a region where the inclined side surface of the dam DAM is to be formed and an exposure process is performed, thereby forming the dam DAM having at least one side surface inclined less than 90 degrees. Although it has been described above that the dam DAM is formed simultaneously with the bank area BNKA, the disclosure is not limited thereto.

The light-emitting layer 172 of the display area DA is formed by a deposition process or a solution process. Next, the common electrode 173 is disposed on the light-emitting layer 172. The common electrode 173 may be formed by a physical vapor deposition method such as the sputtering method. In another modified example, a bank may include a first dam, a second dam outside the first dam, and a plurality of organic layers outside the second dam.

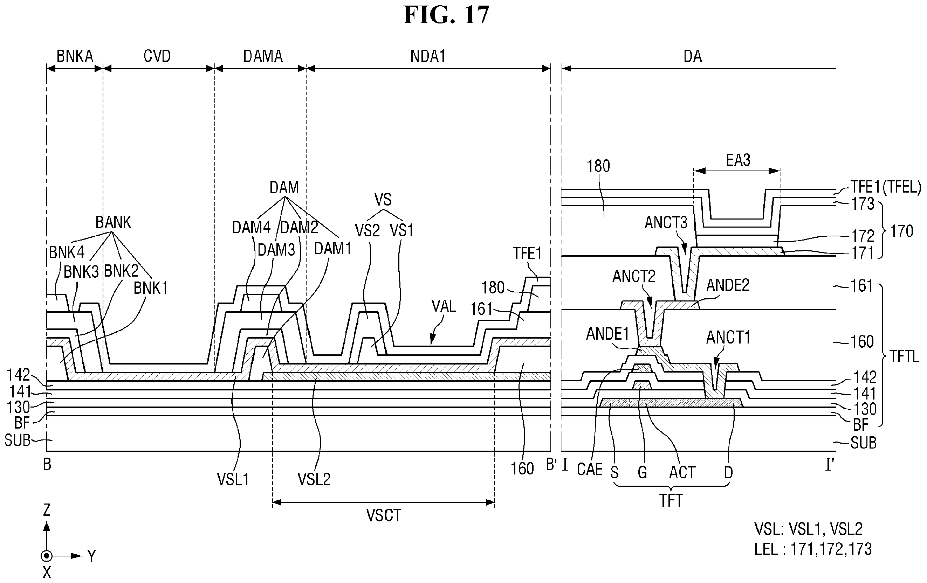

Referring to FIGS. 17 and 18, in operation S110 of forming the encapsulation layer TFEL using an inorganic insulating material and an organic insulating material to cover the display area DA of the substrate SUB, the first inorganic encapsulation layer TFE1 including an inorganic insulating material is disposed to cover the display area DA. Next, droplets of the organic insulating material are dropped on the first inorganic encapsulation layer TFE1 and the process waits until the liquid drops are diffused over the entire display area. The diffused droplets are cured to form the organic encapsulation layer TFE2.

In this case, as shown in FIG. 18, when the droplets of the organic insulating material are dropped on the first inorganic encapsulation layer TFE1, the liquid drops may pass through the display area DA and through the valley structure VS in the first non-display area NDA1 to spread to the dam DAM. The liquid drops may overflow beyond the dam DAM, the valley structure VS or the like to form a remaining layer MN. In another embodiment, droplets for forming the organic encapsulation layer TFE2 may overflow beyond the dam DAM.

In another embodiment, the first power line VSL may be disposed in the first non-display area NDA1 disposed between the dam area DAMA and the display area DA. When droplets overflow into the first non-display area NDA1, the remaining layer MN may be formed on the first permeation prevention patterns TP1 of the first power line VSL or between the first permeation prevention patterns TP1 thereof.

Referring to FIGS. 19 and 20, in operation S120 of inspecting the presence or absence of a remaining layer including the organic insulating material, which is formed in the remaining area of the encapsulation layer except for the display area, using a filter 52 that passes light in a predetermined wavelength range, monochromatic light is irradiated to the remaining area of the substrate SUB except for the display area DA, and the monochromatic light reflected from the substrate SUB is observed with a microscope 53 to check interference fringes. In this case, the remaining area may include at least one of the dam portion and the metal line. Further, the predetermined wavelength range is from about 500 nanometers (nm) to about 600 nm, preferably from about 575 nm to about 585 nm.

In operation S120 of inspecting the presence or absence of the remaining layer, monochromatic light may be irradiated to one or more of the top surface, the bottom surface, and the side surface of the substrate, and the monochromatic light reflected from the substrate may be observed with the microscope.

Referring to FIG. 20, an inspection device 5 may include a light source 51, the filter 52, and the microscope 53. In addition, it may further include a collimating lens R12 and a beam splitter R11.

In an embodiment, monochromatic light emitted from the light source 51 is irradiated to be incident on an organic material, for inspection. The monochromatic light passes through the collimating lens R12 and the filter 52 that passes light in a predetermined wavelength range. Thereafter, the monochromatic light is vertically incident on the organic material by the beam splitter R11. A part of the incident light (monochromatic light incident on the organic material) is reflected from the surface of the droplet, and a part of the remaining light passes through the organic material and is reflected on the first inorganic encapsulation layer TFE1. The reflected light is observed with the microscope. In this case, in the reflected light, a part of the monochromatic light, which has been reflected from the surface of the organic material, and a part of the monochromatic light, which has been reflected on the first inorganic encapsulation layer TFE1 after passing through the organic material, cause constructive or destructive interference with each other according to the effect of Newton's ring, thereby forming interference fringes of a plurality of bands. At this time, the intervals between the interference fringes are different in size according to the slope of the organic material. As the slope of the organic material becomes steeper, the interval of the interference fringes becomes smaller. That is, the interval of the interference fringes is relatively large at a gentle slope, and the interval of the interference fringes is relatively small at a steep slope. This may be used to estimate the approximate height of organic material.

For reference, a destructive interference condition is expressed by Equation 1 below.

[Equation 1]

$$2n_1 d_m = (m + \frac{1}{2})\lambda$$

Here, m is a fringe order, e.g., 0, 1, 2, 3, ... , and $n_1$ is a refractive index of the organic material, $\lambda$ is a wavelength of light, and $d_m$ is a thickness of the organic material.

Therefore, in the case of m (fringe order) = 0, $2n_1 d_0 = \frac{1}{2}\lambda$ is established, in the case of m (fringe order) = 1, $2n_1 d_1 = \frac{3}{2}\lambda$ is established, and in the case of m (fringe order) = 2, $2n_1 d_2 = \frac{5}{2}\lambda$ is established.

That is, in the case of $d_1 = 3d_0$, $d_2 = 5d_0$, ... , the destructive interference occurs. Due to the destructive interference, a dark band is observed in the interference fringes.

At this time, constructive or destructive interference occurs, and thus the interference fringes are observed. A fringe corresponding to the constructive interference appears in a bright color, and a fringe corresponding to the destructive interference appears in a dark color.

FIG. 21 is a diagram illustrating an embodiment of interference fringes formed by an organic material to correspond to the dam area DAMA and first non-display area NDA1 of FIG. 18.

As shown in FIG. 21, the formation of the remaining layer MN between the valley structure VS and the dam area DAM may be easily confirmed with the interference fringes formed by the organic material.

Referring back to FIG. 15, in the manufacturing method of the display panel, when it is determined that the remaining layer is present as the inspection result, the remaining layer may be removed by a plasma ashing process in operation S130 of removing the remaining layer. In this case, the conditions of the plasma ashing process may be controlled based on the difference in the intervals of the interference fringes that corresponds to the thickness of the remaining layer.

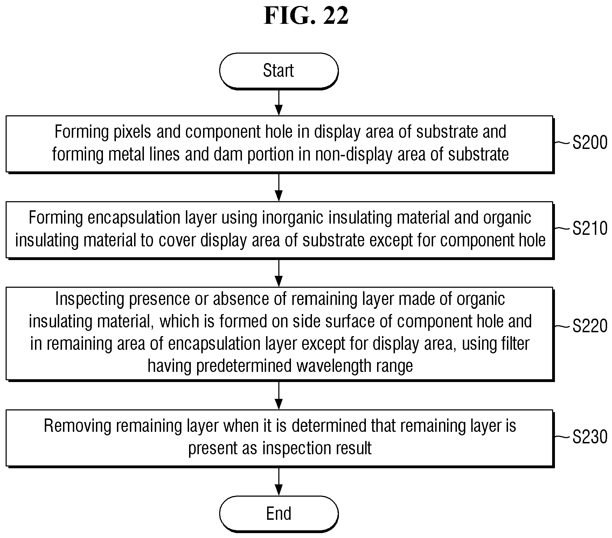

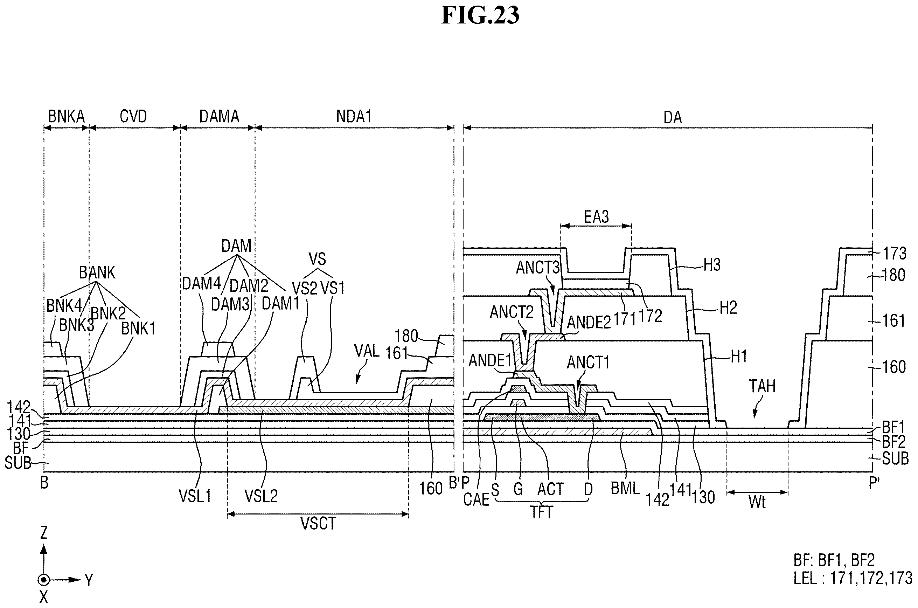

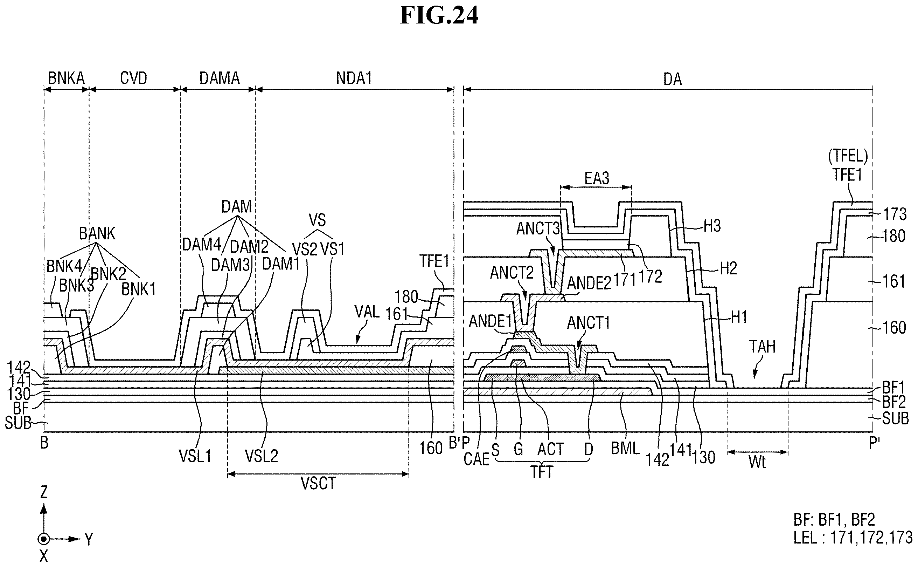

FIG. 22 is a flowchart illustrating an embodiment of a manufacturing method of a display panel according to the disclosure. FIGS. 23 and 24 are cross-sectional views illustrating an embodiment of the manufacturing method of the display panel according to the disclosure. FIGS. 22 to 24 are similar to the manufacturing method of the display panel described with reference to FIGS. 15 to 21 except for the component hole TAH and the lower metal layer BML, and thus the redundant descriptions will be omitted.

Referring to FIG. 23, the manufacturing method of the display panel may include forming the pixels TFTL and defining the component hole TAH in the display area DA of the substrate SUB and forming the metal lines VSL1 and VSL2 and the dam portion DAM in the non-display area NDA of the substrate SUB (operation S200), forming the encapsulation layer TFEL using an inorganic insulating material and an organic insulating material to cover the display area DA of the substrate SUB except for the component hole TAH (operation S210), and inspecting the presence or absence of a remaining layer including the organic insulating material, which is formed on the side surface of the component hole TAH and in the remaining area of the encapsulation layer TFEL except for the display area DA, using a filter having a predetermined wavelength range (operation S220). The manufacturing method of the display panel may further include removing the remaining layer (operation S230) when it is determined that the remaining layer is present as the inspection result.

Operation S200 of forming the pixels and defining the component hole TAH in the display area DA of the substrate SUB and forming the metal lines VSL1 and VSL2 and the dam portion DAM in the non-display area NDA of the substrate SUB is the same as operation S100 described with reference to FIG. 15 except for the formation of the component hole TAH, the buffer layer BF, and the lower metal layer BML, and thus the redundant descriptions will be omitted.

First, the second buffer layer BF2 is formed in the display area DA and the non-display area NDA of the substrate SUB. The lower metal layer BML is formed on the second buffer layer BF2 in an area where pixels will be formed, to be adjacent to the transmission area TA. The lower metal layer BML corresponds to the component area.

The first buffer layer BF1 is formed on the lower metal layer BML. The first buffer layer BF1 and the second buffer layer BF2 may be formed using a chemical vapor deposition method.

The buffer layer BF may include a plurality of inorganic layers BF1 and BF2 that are alternately stacked. In an embodiment, the buffer layer BF may be formed as a multilayer in which one or more inorganic layers selected from a silicon oxide layer (SiOx), a silicon nitride layer (SiNx), and a silicon oxynitride (SiON) are alternately stacked, for example. The buffer layer BF may be formed using the chemical vapor deposition method.

The gate insulating layer 130, the first inter-insulating layer 141, the second inter-insulating layer 142, and the first organic layer 160 of the display area DA may define the first hole H1 that corresponds to the transmission area TA. The first buffer BF1 may be exposed by the first hole H1. The second organic layer 161 defines the second hole H2 corresponding to the transmission area TA. The light-emitting unit defining layer 180 defines the third hole H3 in the transmission area TA. In this case, the first hole H1, the second hole H2, and the third hole H3 may overlap each other. The third hole H3 is equal to or larger than the second hole H2. The second hole H2 is equal to or larger than the first hole H1.

In operation S200, a plurality of permeation prevention patterns is formed in the metal lines VSL1 and VSL2 in the non-display area NDA of the substrate SUB by patterning. The plurality of permeation prevention patterns may have a circular shape, an elliptic shape, or a polygonal shape in a plan view.

Thereafter, operation S210 of forming the encapsulation layer TFEL using an inorganic insulating material and an organic insulating material to cover the display area DA of the substrate SUB except for the component hole TAH, and operation S220 of inspecting the presence or absence of a remaining layer including the organic insulating material, which is formed on the side surface of the component hole TAH and in the remaining area of the encapsulation layer TFEL except for the display area DA, using a filter having a predetermined wavelength range may be performed.

Referring to FIGS. 22 and 24, in operation S210 of forming the encapsulation layer TFEL using an inorganic insulating material and an organic insulating material to cover the display area DA of the substrate SUB except for the component hole TAH, first, the first inorganic encapsulation layer TFE1 is formed in the display area DA including the side surface of the component hole TAH and the non-display area NDA.

Using an organic insulating material, droplets are dropped on the first inorganic encapsulation layer TFE1 to cover the display area DA except for the component hole TAH. The process waits until the droplets are diffused throughout the display area DA except for the component hole TAH. The diffused droplets are cured to form the organic encapsulation layer TFE2.

Next, returning to FIG. 22, in operation S220 of inspecting the presence or absence of a remaining layer including the organic insulating material, which is formed on the side surface of the component hole TAH and in the remaining area of the encapsulation layer TFEL except for the display area DA, using a filter that passes light in a predetermined wavelength range, monochromatic light is irradiated to the remaining area of the substrate SUB except for the display area DA, and the monochromatic light reflected from the substrate SUB is observed with the microscope 53 to check interference fringes. In this case, the remaining area may include at least one of the dam portion and the metal line. Further, the predetermined wavelength range is from about 500 nm to about 600 nm, preferably from about 575 nm to about 585 nm.

In operation S220 of inspecting the presence or absence of the remaining layer, monochromatic light may be irradiated to any one or more of the top surface, the bottom surface, and the side surface of the substrate, and the monochromatic light reflected from the substrate may be observed with the microscope.

Inspecting the remaining layer is the same as that described with reference to FIGS. 19 and 20, and thus a detailed description thereof will be omitted.

Returning to FIG. 22, in the manufacturing method of the display panel, when it is determined that the remaining layer is present as the inspection result, the remaining layer may be removed by a plasma ashing process in operation S230 of removing the remaining layer. In this case, the conditions of the plasma ashing process may be controlled based on the difference in the intervals of the interference fringes that corresponds to the thickness of the remaining layer.

However, the features of the disclosure are not restricted to the one set forth herein. The above and other features of the disclosure will become more apparent to one of daily skill in the art to which the disclosure pertains by referencing the claims, with functional equivalents thereof to be included therein.

The present invention may be defined by reference to the following clauses:

Clause 1. A manufacturing method of a display panel, the method comprising:

forming pixels in a display area of a substrate, and forming a metal wiring and a dam portion in a non-display area of the substrate;
forming an encapsulation layer using an inorganic insulating material and an organic insulating material to cover the display area of the substrate; and
inspecting the presence or absence of a remaining layer including the organic insulating material, which is formed in a remaining area of the encapsulation layer except for the display area, using a filter having a predetermined wavelength range.

Clause 2. The manufacturing method of clause 1, further comprising removing the remaining layer when it is determined that the remaining layer is present as a result of the inspecting.

Clause 3. The manufacturing method of clause 1 or clause 2, wherein the forming the metal wiring and the dam portion in the non-display area of the substrate comprises forming the metal wiring by patterning after depositing a conductive layer in the non-display area of the substrate.

Clause 4. The manufacturing method of clause 3, wherein a plurality of permeation prevention patterns protruding outward is formed in the metal wiring.

Clause 5. The manufacturing method of clause 4, wherein the plurality of permeation prevention patterns has a circular shape, an elliptic shape, or a polygonal shape in a plan view.

Clause 6. The manufacturing method of any one of clauses 1 to 5, wherein the forming the encapsulation layer comprises:

disposing an inorganic encapsulation layer including the inorganic insulating material to cover the display area;
dropping droplets of the organic insulating material on the inorganic encapsulation layer; waiting until the droplets are diffused throughout the display area; and forming an organic encapsulation layer by curing the diffused droplets.

Clause 7. The manufacturing method of any one of clauses 1 to 6, wherein the forming the dam portion comprises: forming a bank including a dam and a plurality of organic layers outside the dam.

Clause 8. The manufacturing method of any one of clauses 1 to 6, wherein the forming the dam portion comprises forming a bank including a first dam, a second dam outside the first dam, and a plurality of organic layers outside the second dam.

Clause 9. The manufacturing method of any one of clauses 2 to 8, wherein the inspecting the presence or the absence of the remaining layer including the organic insulating material, which is formed in the remaining area of the encapsulation layer except for the display area, using the filter having the predetermined wavelength range comprises irradiating monochromatic light to the remaining area of the substrate except for the display area and observing the monochromatic light reflected from the substrate with a microscope to check interference fringes.

Clause 10. The manufacturing method of clause 9, wherein the remaining area comprises at least one of the dam portion and the metal wiring.

Clause 11. The manufacturing method of clause 9 or clause 10, wherein the inspecting the presence or the absence of the remaining layer comprises irradiating the monochromatic light to any one or more of a top surface, a bottom surface, and a side surface of the substrate and observing the monochromatic light reflected from the substrate with the microscope to check the interference fringes.

Clause 12. The manufacturing method of any one of clauses 9 to 11, wherein the removing the remaining layer comprises removing the remaining layer by a plasma ashing process.

Clause 13. The manufacturing method of clause 12, wherein conditions of the plasma ashing process are controlled based on a difference in intervals of the interference fringes corresponding to a thickness of the remaining layer.

Clause 14. The manufacturing method of any one of clauses 1 to 13, wherein the predetermined wavelength range is from 575 nanometers to 585 nanometers.

Clause 15. A manufacturing method of a display panel, the method comprising: forming pixels and defining a component hole in a display area of a substrate, and forming a metal wiring and a dam portion in a non-display area of the substrate;

forming an encapsulation layer using an inorganic insulating material and an organic insulating material to cover the display area of the substrate except for the component hole; and
inspecting presence or absence of a remaining layer including the organic insulating material, which is formed on a side surface of the component hole and in a remaining area of the encapsulation layer except for the display area, using a filter having a predetermined wavelength range.

Clause 16. The manufacturing method of clause 15, further comprising removing the remaining layer when it is determined that the remaining layer is present as a result of the inspecting.

Clause 17. The manufacturing method of clause 15 or clause 16, wherein the component hole overlaps a region where a component is disposed.

Clause 18. The manufacturing method of clause 17, wherein the component is any one of an illuminance sensor, an iris sensor, and a camera.

Clause 19. The manufacturing method of any one of clauses 15 to 18, wherein the forming the metal wiring and the dam portion in the non-display area of the substrate comprises forming the metal wiring by patterning after depositing a conductive layer in the non-display area of the substrate.

Clause 20. The manufacturing method of any one of clauses 15 to 19, wherein a plurality of permeation prevention patterns protruding outward is formed in the metal wiring.

Clause 21. The manufacturing method of clause 20, wherein the plurality of permeation prevention patterns has a circular shape, an elliptic shape, or a polygonal shape in a plan view.

Clause 22. The manufacturing method of any one of clauses 15 to 21, wherein the forming the pixels and the defining the component hole in the display area of the substrate, and forming the metal wiring and the dam portion in the non-display area of the substrate comprises disposing a lower metal layer on the substrate in a component area where the component hole is defined, and forming the pixels on the lower metal layer.

Clause 23. The manufacturing method of any one of clauses 15 to 22, wherein the forming the encapsulation layer comprises:

disposing an inorganic encapsulation layer including the inorganic insulating material to cover the display area of the substrate except for the component hole;
dropping droplets of the organic insulating material on the inorganic encapsulation layer; waiting until the droplets are diffused throughout the display area; and forming an organic encapsulation layer by curing the diffused droplets.

Clause 24. The manufacturing method of any one of clauses 15 to 23, wherein the forming the dam portion comprises: forming a bank including a dam and plurality of organic layers outside the dam.

Clause 25. The manufacturing method of any one of clauses 15 to 23, wherein the forming the dam portion comprises forming a bank including a first dam, a second dam outside the first dam, and a plurality of organic layers outside the second dam.

Clause 26. The manufacturing method of any one of clauses 17 to 25, wherein the inspecting the presence or the absence of the remaining layer including the organic insulating material, which is formed on the side surface of the component hole and in the remaining area except for the display area comprises irradiating monochromatic light to the side surface of the component hole and the remaining area except for the display area and observing the monochromatic light reflected from the substrate with a microscope to check interference fringes.

Clause 27. The manufacturing method of clause 26, wherein the remaining area comprises at least one of the dam portion and the metal wiring.

Clause 28. The manufacturing method of clause 26 or clause 27, wherein the inspecting the presence or the absence of the remaining layer comprises irradiating the monochromatic light to any one or more of a top surface, a bottom surface, and a side surface of the substrate and observing the monochromatic light reflected from the substrate with the microscope to check the interference fringes.

**Claims**

1. A manufacturing method of a display panel, the method comprising:

   forming pixels in a display area of a substrate, and forming a metal wiring and a dam portion in a non-display area of the substrate;
   forming an encapsulation layer using an inorganic insulating material and an organic insulating material to cover the display area of the substrate; and
   inspecting the presence or absence of a remaining layer including the organic insulating material, which is formed in a remaining area of the encapsulation layer except for the display area, using a filter having a predetermined wavelength range.

2. The manufacturing method of claim 1, further comprising removing the remaining layer when it is determined that the remaining layer is present as a result of the inspecting.

3. The manufacturing method of claim 1 or claim 2, wherein the forming the metal wiring and the dam portion in the non-display area of the substrate comprises forming the metal wiring by patterning after depositing a conductive layer in the non-display area of the substrate.

4. The manufacturing method of claim 3, wherein a plurality of permeation prevention patterns protruding outward is formed in the metal wiring, optionally wherein the plurality of permeation prevention patterns has a circular shape, an elliptic shape, or a polygonal shape in a plan view.

5. The manufacturing method of any one of claims 1 to 4, wherein the forming the encapsulation layer comprises:

disposing an inorganic encapsulation layer including the inorganic insulating material to cover the display area;
dropping droplets of the organic insulating material on the inorganic encapsulation layer;
waiting until the droplets are diffused throughout the display area; and
forming an organic encapsulation layer by curing the diffused droplets.

6. The manufacturing method of any one of claims 1 to 5, wherein the forming the dam portion comprises:

(i) forming a bank including a dam and a plurality of organic layers outside the dam; or
(ii) forming a bank including a first dam, a second dam outside the first dam, and a plurality of organic layers outside the second dam.

7. The manufacturing method of any one of claims 2 to 6, wherein the inspecting the presence or the absence of the remaining layer including the organic insulating material, which is formed in the remaining area of the encapsulation layer except for the display area, using the filter having the predetermined wavelength range comprises irradiating monochromatic light to the remaining area of the substrate except for the display area and observing the monochromatic light reflected from the substrate with a microscope to check interference fringes.

8. The manufacturing method of claim 7, wherein:

(i) the remaining area comprises at least one of the dam portion and the metal wiring; and/or
(ii) the inspecting the presence or the absence of the remaining layer comprises irradiating the monochromatic light to any one or more of a top surface, a bottom surface, and a side surface of the substrate and observing the monochromatic light reflected from the substrate with the microscope to check the interference fringes; and/or
(iii) the removing the remaining layer comprises removing the remaining layer by a plasma ashing process, optionally wherein conditions of the plasma ashing process are controlled based on a difference in intervals of the interference fringes corresponding to a thickness of the remaining layer.

9. The manufacturing method of any one of claims 1 to 8, wherein the predetermined wavelength range is from 575 nanometers to 585 nanometers.

10. A manufacturing method of a display panel, the method comprising:

forming pixels and defining a component hole in a display area of a substrate, and forming a metal wiring and a dam portion in a non-display area of the substrate;
forming an encapsulation layer using an inorganic insulating material and an organic insulating material to cover the display area of the substrate except for the component hole; and
inspecting presence or absence of a remaining layer including the organic insulating material, which is formed on a side surface of the component hole and in a remaining area of the encapsulation layer except for the display area, using a filter having a predetermined wavelength range.

11. The manufacturing method of claim 10, wherein:

(i) the method further comprises removing the remaining layer when it is determined that the remaining layer is present as a result of the inspecting; and/or
(ii) the component hole overlaps a region where a component is disposed, optionally wherein the component is any one of an illuminance sensor, an iris sensor, and a camera; and/or
(iii) the forming the metal wiring and the dam portion in the non-display area of the substrate comprises forming the metal wiring by patterning after depositing a conductive layer in the non-display area of the substrate; and/or
(iv) a plurality of permeation prevention patterns protruding outward is formed in the metal wiring, optionally wherein the plurality of permeation prevention patterns has a circular shape, an elliptic shape, or a polygonal shape in a plan view.

12. The manufacturing method of claim 10 or claim 11, wherein:

(i) the forming the pixels and the defining the component hole in the display area of the substrate, and forming the metal wiring and the dam portion in the non-display area of the substrate comprises disposing a lower metal layer on the substrate in a component area where the component hole is defined, and forming the pixels on the lower metal layer; and/or
(ii)the forming the encapsulation layer comprises:

disposing an inorganic encapsulation layer including the inorganic insulating material to cover the display area of the substrate except for the component hole;
dropping droplets of the organic insulating material on the inorganic encapsulation layer;
waiting until the droplets are diffused throughout the display area; and
forming an organic encapsulation layer by curing the diffused droplets.

13. The manufacturing method of any one of claims 10 to 12, wherein the forming the dam portion comprises:

(i) forming a bank including a dam and plurality of organic layers outside the dam; or
(ii) forming a bank including a first dam, a second dam outside the first dam, and a plurality of organic layers outside the second dam.

14. The manufacturing method of any one of claims 11 to 13, wherein the inspecting the presence or the absence of the remaining layer including the organic insulating material, which is formed on the side surface of the component hole and in the remaining area except for the display area comprises irradiating monochromatic light to the side surface of the component hole and the remaining area except for the display area and observing the monochromatic light reflected from the substrate with a microscope to check interference fringes.

15. The manufacturing method of claim 14, wherein:

(i) the remaining area comprises at least one of the dam portion and the metal wiring; and/or
(ii) the inspecting the presence or the absence of the remaining layer comprises irradiating the monochromatic light to any one or more of a top surface, a bottom surface, and a side surface of the substrate and observing the monochromatic light reflected from the substrate with the microscope to check the interference fringes.

**FIG. 1**

## FIG. 2

# FIG. 3

# FIG. 4

**FIG. 5**

LEL : 171,172,173

EP 4 243 591 A1

# FIG. 6

31

**FIG. 7**

VDL: VDL1, VDL2, VDL3, TP2
VSL: VSL1, TP1

## FIG. 8

# FIG. 9

# FIG. 10

EP 4 243 591 A1

# FIG. 11

# FIG. 12

DA: MDA, CA

# FIG. 13

FIG. 14

TA

TFE3
TFE2 } TFEL
TFE1

H3

EA3

ANCT3

180

EA3

173
172 } 170
171

161

160

H2

H1

TAH

Wt

171 172

ANCT1

ANCT2

ANDE2

ANDE1

D
ACT } TFT
S  G
S

BML

CAE

142
141
130
BF1
BF2 } 
SUB

TFTL

BF: BF1, BF2

P                                                      P'

Z
Y
X

# FIG. 15

Start

Forming pixels in display area of substrate and forming metal lines and dam portion in non-display area of substrate — S100

Forming encapsulation layer using inorganic insulating material and organic insulating material to cover display area of substrate — S110

Inspecting presence or absence of remaining layer made of organic insulating material, which is formed in remaining area of encapsulation layer except for display area, using filter having predetermined wavelength range — S120

Removing remaining layer when it is determined that remaining layer is present as inspection result — S130

End

# FIG. 16

EP 4 243 591 A1

VSL: VSL1, VSL2
LEL : 171,172,173

**FIG. 17**

EP 4 243 591 A1

VSL: VSL1, VSL2
LEL : 171,172,173

# FIG. 18

# FIG. 19

# FIG. 20

5: 51, 52, 53

# FIG. 21

DAM MN VS

# FIG. 22

```
        ┌─────────────┐
        │    Start    │
        └──────┬──────┘
               │
               ▼
┌──────────────────────────────────────────────────────┐
│  Forming pixels and component hole in display area of  │   ~S200
│  substrate and forming metal lines and dam portion in  │
│  non-display area of substrate                         │
└──────────────────────────┬─────────────────────────────┘
                           │
                           ▼
┌──────────────────────────────────────────────────────┐
│  Forming encapsulation layer using inorganic           │   ~S210
│  insulating material and organic insulating material   │
│  to cover display area of substrate except for         │
│  component hole                                        │
└──────────────────────────┬─────────────────────────────┘
                           │
                           ▼
┌──────────────────────────────────────────────────────┐
│  Inspecting presence or absence of remaining layer     │   ~S220
│  made of organic insulating material, which is formed   │
│  on side surface of component hole and in remaining     │
│  area of encapsulation layer except for display area,   │
│  using filter having predetermined wavelength range     │
└──────────────────────────┬─────────────────────────────┘
                           │
                           ▼
┌──────────────────────────────────────────────────────┐
│  Removing remaining layer when it is determined that   │   ~S230
│  remaining layer is present as inspection result       │
└──────────────────────────┬─────────────────────────────┘
                           │
                           ▼
                    ┌─────────────┐
                    │     End     │
                    └─────────────┘
```

**FIG.23**

EP 4 243 591 A1

# FIG.24

EP 4 243 591 A1

Europäisches
Patentamt

European
Patent Office

Office européen
des brevets

# EUROPEAN SEARCH REPORT

**Application Number**

EP 23 16 0300

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/190170 A1 (YANG JEONG-BOK [KR]) 5 July 2018 (2018-07-05) | 1,2,5,6, 9 | INV. H10K59/131 |
| Y | * paragraphs [0067], [0068], [0069], [0070], [0071], [0074], [0075], | 3,4, 10-13 | H10K59/80 H10K71/70 |
| A | [0077], [0083], [0102], [0105]; figure 3 * ----- | 7,8,14, 15 | |
| Y | US 2021/225992 A1 (LONG YUE [CN] ET AL) 22 July 2021 (2021-07-22) * paragraphs [0190] - [0196], [0208], [0212]; figures 19,20 * ----- | 3,4 | |
| Y | US 2020/295300 A1 (CHUNG JINKOO [KR] ET AL) 17 September 2020 (2020-09-17) * paragraphs [0050], [0055], [0056], [0057], [0099], [0100], [0120], [0123]; figures 1,2,6 * ----- | 10-13 | |
| A | US 2020/194534 A1 (PARK JUNHYUN [KR] ET AL) 18 June 2020 (2020-06-18) * paragraphs [0140], [0141], [0142], [0147]; figures 1,3A * ----- | 1-15 | **TECHNICAL FIELDS SEARCHED (IPC)** H10K |
| A | US 2007/247622 A1 (SUN GANG [US]) 25 October 2007 (2007-10-25) * paragraphs [0007], [0033]; figure 1 * ----- | 1-15 | |

The present search report has been drawn up for all claims

| Place of search | Date of completion of the search | Examiner |
|---|---|---|
| The Hague | 7 July 2023 | Faou, Marylène |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 0300

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2023

| Patent document cited in search report | Publication date | Patent family member(s) | Publication date |
|---|---|---|---|
| US 2018190170 A1 | 05-07-2018 | CN 108257886 A | 06-07-2018 |
| | | KR 20180077898 A | 09-07-2018 |
| | | US 2018188186 A1 | 05-07-2018 |
| | | US 2018190170 A1 | 05-07-2018 |
| US 2021225992 A1 | 22-07-2021 | AU 2019279976 B1 | 19-11-2020 |
| | | BR 112020000834 A2 | 08-02-2022 |
| | | CN 112602199 A | 02-04-2021 |
| | | EP 4009373 A1 | 08-06-2022 |
| | | JP 2022550490 A | 02-12-2022 |
| | | RU 2729699 C1 | 11-08-2020 |
| | | TW 202107700 A | 16-02-2021 |
| | | US 2021225992 A1 | 22-07-2021 |
| | | WO 2021017011 A1 | 04-02-2021 |
| US 2020295300 A1 | 17-09-2020 | CN 111697029 A | 22-09-2020 |
| | | EP 3709367 A1 | 16-09-2020 |
| | | KR 20200109435 A | 23-09-2020 |
| | | US 2020295300 A1 | 17-09-2020 |
| | | US 2022123260 A1 | 21-04-2022 |
| US 2020194534 A1 | 18-06-2020 | CN 111326554 A | 23-06-2020 |
| | | EP 3667732 A2 | 17-06-2020 |
| | | KR 20200073349 A | 24-06-2020 |
| | | US 2020194534 A1 | 18-06-2020 |
| | | US 2022123098 A1 | 21-04-2022 |
| US 2007247622 A1 | 25-10-2007 | US 2007247622 A1 | 25-10-2007 |
| | | US 2009324056 A1 | 31-12-2009 |
| | | US 2012070065 A1 | 22-03-2012 |

EPO FORM P0459

For more details about this annex : see Official Journal of the European Patent Office, No. 12/82